# EUROPEAN PATENT SPECIFICATION

(11) **EP 4 195 484 B1**
(45) Date of publication and mention of the grant of the patent: **28.10.2026**
(21) Application number: 22212361.4
(22) Date of filing: 08.12.2022
(51) Int. Cl.: H02M 3/158, H02M 7/483, H02M 1/00

(54) **BIDIRECTIONAL DIRECT CURRENT CONVERTER AND CONTROL METHOD THEREOF**
BIDIREKTIONALER GLEICHSTROMWANDLER UND STEUERUNGSVERFAHREN DAFÜR
CONVERTISSEUR DE COURANT CONTINU BIDIRECTIONNEL ET SON PROCÉDÉ DE COMMANDE

(30) Priority: 08.12.2021 CN 202111489706
(43) Date of publication of application: 14.06.2023
(73) Proprietor: Huawei Digital Power Technologies Co., Ltd., Shenzhen 518043 (CN)
(72) Inventor: WANG, Jun, 518043 Shenzhen (CN); SHI, Lei, 518043 Shenzhen (CN); LIU, Yunfeng, 518043 Shenzhen (CN); WANG, Zhaohui, 518043 Shenzhen (CN)
(74) Representative: Gill Jennings & Every LLP

(56) References cited:
- EP-A1- 3 242 385
- EP-A1- 3 709 497
- EP-A1- 3 846 329
- WO-A1-2012/074967
- WO-A2-2020/112207
- CN-A- 111 200 309
- US-A1- 2018 026 518
- VASIC MIROSLAV ET AL: "Ultraefficient Voltage Doubler Based on a GaN Resonant Switched-Capacitor Converter", IEEE JOURNAL OF EMERGING AND SELECTED TOPICS IN POWER ELECTRONICS, IEEE, PISCATAWAY, NJ, USA, vol. 7, no. 2, 1 June 2019 (2019-06-01), pages 622 - 635, XP011721923, ISSN: 2168-6777, [retrieved on 20190430], DOI: 10.1109/JESTPE.2019.2899180
- GUI HANDONG ET AL: "Modeling and Mitigation of Multiloops Related Device Overvoltage in Three-Level Active Neutral Point Clamped Converter", IEEE TRANSACTIONS ON POWER ELECTRONICS, INSTITUTE OF ELECTRICAL AND ELECTRONICS ENGINEERS, USA, vol. 35, no. 8, 27 December 2019 (2019-12-27), pages 7947 - 7959, XP011785673, ISSN: 0885-8993, [retrieved on 20200423], DOI: 10.1109/TPEL.2019.2962621
- CHEN SIYUAN ET AL: "Bidirectional H8 AC-DC Topology Combining Advantages of Both Diode-Clamped and Flying-Capacitor Three-Level Converters", IEEE JOURNAL OF EMERGING AND SELECTED TOPICS IN POWER ELECTRONICS, IEEE, PISCATAWAY, NJ, USA, vol. 10, no. 4, 10 June 2021 (2021-06-10), pages 3643 - 3651, XP011916814, ISSN: 2168-6777, [retrieved on 20210611], DOI: 10.1109/JESTPE.2021.3088390

## Description

### TECHNICAL FIELD

This application relates to the field of energy technologies, and more specifically, to a bidirectional direct current converter and a control method thereof in the field of energy technologies.

### BACKGROUND

A direct current converter is a power electronic apparatus that can convert a direct current of one voltage class into a direct current of another voltage class. Direct current converters are usually classified into unidirectional direct current converters and bidirectional direct current converters. A unidirectional direct current converter is a direct current converter that can perform only unidirectional power transmission, and a bidirectional direct current converter is a direct current converter that can perform bidirectional power transmission.

For the bidirectional direct current converter, how to reduce an inductance of an inductor in the bidirectional direct current converter by controlling a switching transistor in the bidirectional direct current converter, to reduce a size and costs of the inductor becomes a technical problem that needs to be resolved urgently.

WO2012074967A1 relates to fully integrated 3-level DC/DC CONVERTER for nanosecond-scale dynamic voltage scaling with fast shunt regulation. EP3242385A1 relates to a load adaptable boost DC-DC power converter. US2018026518A1 relates to multi-stage multilevel DC-DC step-down converter. CN111200309A relates to bidirectional direct-current charger circuit. WO2020112207A2 relates to switched-capacitor power conversion system and control method. EP3709497A1 relates to cascaded pulse width modulation converter control. EP3846329A1 relates to DC balancer circuit with ZVS.

VASIC MIROSLAV ET AL, "Ultraefficient Voltage Doubler Based on a GaN Resonant Switched-Capacitor Converter", IEEE JOURNAL OF EMERGING AND SELECTED TOPICS IN POWER ELECTRONICS, IEEE, PISCATAWAY, NJ, USA, vol. 7, no. 2, doi:10.1109/JESTPE.2019.2899180, ISSN 2168-6777, (20190601), pages 622 - 635, (20190430), relates to voltage doubler based on a GaN resonant switched-capacitor converter.

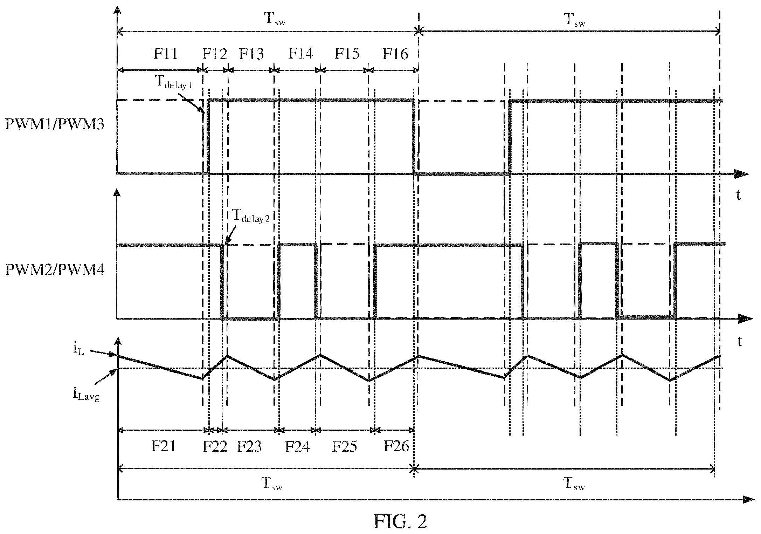

GUI HANDONG ET AL, "Modeling and Mitigation of Multiloops Related Device Overvoltage in Three-Level Active Neutral Point Clamped Converter", IEEE TRANSACTIONS ON POWER ELECTRONICS, INSTITUTE OF ELECTRICAL AND ELECTRONICS ENGINEERS, USA, vol. 35, no. 8, doi:10.1109/TPEL.2019.2962621, ISSN 0885-8993, (20191227), pages 7947 - 7959, (20200423), XP011785673 [Y] 1-7 * Section II. MODULATION SCHEMES AND LOOP ANALYSIS OF 3L-ANPC CONVERTER;; figure 2 * DOI: http://dx.doi.org/10.1109/TPEL.2019.2962621 relates to Modeling and Mitigation of Multiloops Related Device Overvoltage in Three-Level Active Neutral Point Clamped Converter.

### SUMMARY

This application provides a bidirectional direct current converter and a control method thereof. A controller performs complementary control on a first switching transistor and a third switching transistor, and performs complementary control on a second switching transistor and a fourth switching transistor, to reduce an inductance of an inductor, thereby reducing a size and costs of the inductor, and further reducing a size and costs of the entire bidirectional direct current converter.

The invention has been defined in the independent claims. Further specific technical features have been defined in the dependent claims.

According to a first aspect, this application provides a bidirectional direct current converter. The bidirectional direct current converter may include a first switching transistor, a second switching transistor, a third switching transistor, a fourth switching transistor, a capacitor, an inductor, and a controller.

The bidirectional direct current converter may include a first direct current terminal, a second direct current terminal, a third direct current terminal, and a fourth direct current terminal.

In an example, the first direct current terminal and the second direct current terminal may constitute an input terminal of the bidirectional direct current converter, and the third direct current terminal and the fourth direct current terminal may constitute an output terminal of the bidirectional direct current converter. Therefore, the bidirectional direct current converter may implement forward power transmission by using the four direct current terminals.

In another example, the third direct current terminal and the fourth direct current terminal may constitute an input terminal of the bidirectional direct current converter, and the first direct current terminal and the second direct current terminal may constitute an output terminal of the bidirectional direct current converter. Therefore, the bidirectional direct current converter may implement reverse power transmission by using the four direct current terminals.

Further, a first terminal of the inductor is configured to connect to the first direct current terminal, and a second terminal of the inductor is configured to connect to a first node. A first electrode of the first switching transistor is configured to connect to the first node, and a second electrode of the first switching transistor is configured to connect to a second node. A first electrode of the second switching transistor is configured to connect to the second node, and a second electrode of the second switching transistor is configured to connect to the second direct current terminal and the fourth direct current terminal. A first electrode of the third switching transistor is configured to connect to the first node, and a second electrode of the third switching transistor is configured to connect to a third node. A first electrode of the fourth switching transistor is configured to connect to the third node, and a second electrode of the fourth switching transistor is configured to connect to the third direct current terminal. A first terminal of the capacitor is configured to connect to the third node, and a second terminal of the capacitor is configured to connect to the second node. The controller is configured to connect to the first switching transistor, the second switching transistor, the third switching transistor, and the fourth switching transistor.

Based on the foregoing connection relationship, the controller is configured to: perform complementary control on the first switching transistor and the third switching transistor, and perform complementary control on the second switching transistor and the fourth switching transistor.

The complementary control is used to indicate that two switching transistors in complementary control cannot be simultaneously turned on or off. For example, the first switching transistor and the third switching transistor cannot be simultaneously turned on or off, and the second switching transistor and the fourth switching transistor cannot be simultaneously turned on or off.

That is, the controller is configured to control the first switching transistor and the third switching transistor not to be simultaneously turned on or off, and the controller further controls the second switching transistor and the fourth switching transistor not to be simultaneously turned on or off.

The controller is further configured to control a quantity of on times of the second switching transistor to be greater than a quantity of on times of the first switching transistor in a same cycle.In one cycle, the controller controls a switching frequency of the second switching transistor to be greater than a switching frequency of the first switching transistor, thereby reducing losses of the first switching transistor and the second switching transistor.

In this application, the controller controls the quantity of on times of the second switching transistor to be different from the quantity of on times of the first switching transistor in a same cycle. This can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, in any cycle of the first switching transistor, there may be a delay between an on moment of the first switching transistor and an on moment of the second switching transistor. That is, the first switching transistor and the second switching transistor are not simultaneously turned on in any cycle.

Further, a cycle of the first switching transistor may be the same as a cycle of the third switching transistor.

In a possible implementation, the controller is further configured to control a quantity of on times of the fourth switching transistor to be greater than a quantity of on times of the third switching transistor in a same cycle. It may also be understood as that, in one cycle, the controller may control a switching frequency of the fourth switching transistor to be greater than a switching frequency of the third switching transistor, thereby reducing losses of the third switching transistor and the fourth switching transistor.

It may be understood that the controller controls the quantity of on times of the fourth switching transistor to be different from the quantity of on times of the third switching transistor in a same cycle. Similarly, this can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

The controller is configured to:
send a first drive signal to the first switching transistor, send a second drive signal to the second switching transistor, send a third drive signal to the third switching transistor, and send a fourth drive signal to the fourth switching transistor. That is, the controller sends the drive signals to the switching transistors, to implement complementary control on the first switching transistor and the third switching transistor, and implement complementary control on the second switching transistor and the fourth switching transistor.

The controller sends the first drive signal to the first switching transistor, to control on and off of the first switching transistor. It may be understood that the first drive signal may be used to indicate the first switching transistor to be turned on, or the first drive signal may be used to indicate the first switching transistor to be turned off.

Similarly, the controller sends the second drive signal to the second switching transistor, to control on and off of the second switching transistor. It may be understood that the second drive signal may be used to indicate the second switching transistor to be turned on, or the second drive signal may be used to indicate the second switching transistor to be turned off.

The controller sends the third drive signal to the third switching transistor, to control on and off of the third switching transistor. It may be understood that the third drive signal may be used to indicate the third switching transistor to be turned on, or the third drive signal may be used to indicate the third switching transistor to be turned off.

The controller sends the fourth drive signal to the fourth switching transistor, to control on and off of the fourth switching transistor. It may be understood that the fourth drive signal may be used to indicate the fourth switching transistor to be turned on, or the fourth drive signal may be used to indicate the fourth switching transistor to be turned off.

Optionally, when the first drive signal is at a high level, the first switching transistor may be turned on; and when the first drive signal is at a low level, the first switching transistor may be turned off.

Similarly, when the third drive signal is at a high level, the third switching transistor may be turned on; and when the third drive signal is at a low level, the third switching transistor may be turned off.

It may be understood that the first drive signal may be complementary to the third drive signal. That is, when the first drive signal is at a high level, the third drive signal may be at a low level. Similarly, when the first drive signal is at a low level, the third drive signal may be at a high level.

It should be noted that there is a delay interval between a falling edge of the first drive signal and a rising edge of the third drive signal. That is, in a range of the delay interval, the first switching transistor and the third switching transistor are simultaneously turned off.

Optionally, when the second drive signal is at a high level, the second switching transistor may be turned on; and when the second drive signal is at a low level, the second switching transistor may be turned off.

Similarly, when the fourth drive signal is at a high level, the fourth switching transistor may be turned on; and when the fourth drive signal is at a low level, the fourth switching transistor may be turned off.

It may be understood that the second drive signal may be complementary to the fourth drive signal. That is, when the second drive signal is at a high level, the fourth drive signal may be at a low level. Similarly, when the second drive signal is at a low level, the fourth drive signal may be at a high level.

Optionally, in any cycle of the first switching transistor, there may be a delay between the on moment of the first switching transistor and the on moment of the second switching transistor. Therefore, in each cycle of the first drive signal, a rising edge of a first drive pulse of N drive pulses in the second drive signal may be behind the falling edge of the first drive signal. That is, there is a delay time (namely, a delay) between a first drive pulse of two drive pulses in the second drive signal and the first drive signal.

Similarly, in each cycle of the third drive signal, a rising edge of a first drive pulse of N drive pulses in the fourth drive signal may be in front of a falling edge of the third drive signal. That is, there is a delay between a first drive pulse of two drive pulses in the fourth drive signal and the third drive signal.

In a possible implementation, the cycle of the first switching transistor may be the same as the cycle of the third switching transistor. Therefore, a cycle of the first drive signal may be the same as a cycle of the third drive signal.

Further, the second drive signal has N drive pulses in each cycle of the first drive signal, that is, the second drive signal and the first drive signal may be two asymmetric drive signals.

Similarly, the fourth drive signal may have N drive pulses in each cycle of the third drive signal, that is, the fourth drive signal PWM and the third drive signal PWM are two asymmetric drive signals.

Further, the inductor has N+1 charging and discharging cycles in each cycle of the first drive signal or the third drive signal, where N is an integer greater than or equal to 3.

It should be noted that there is also a delay interval between a falling edge of the first drive pulse of the N drive pulses in the fourth drive signal and the rising edge of the first drive pulse of the N drive pulses in the second drive signal. In a range of the delay interval, the second switching transistor and the fourth switching transistor are simultaneously turned off.

Because the second drive signal may have N drive pulses in each cycle of the first drive signal, a cycle of the second drive signal is different from the cycle of the first drive signal. Similarly, because the fourth drive signal may also have N drive pulses in each cycle of the third drive signal, a cycle of the fourth drive signal is different from the cycle of the third drive signal.

In the bidirectional direct current converter provided in this application, the controller may send the first drive signal and the second drive signal that are asymmetric to the first switching transistor and the second switching transistor, and send the third drive signal and the fourth drive signal that are asymmetric to the third switching transistor and the fourth switching transistor, so that a quantity of charging and discharging times of the inductor in each cycle of the first drive signal or the third drive signal is increased, that is, the charging and discharging frequency of the inductor is increased. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In addition, in this application, the asymmetric drive signals are sent to the first switching transistor and the second switching transistor, and the asymmetric drive signals are sent to the third switching transistor and the fourth switching transistor, so that a state of the first switching transistor is opposite to a state of the third switching transistor (that is, the first switching transistor is complementary to the third switching transistor), and a state of the second switching transistor is opposite to a state of the fourth switching transistor (that is, the second switching transistor is complementary to the fourth switching transistor). Further, current sharing or complement is implemented between a branch in which the first switching transistor and the second switching transistor are located and a branch in which the third switching transistor and the fourth switching transistor are located (that is, between two branches), so that a voltage of the capacitor remains stable.

In a possible implementation, the N drive pulses in the second drive signal may be in low level time periods of each cycle of the first drive signal.

Certainly, the N drive pulses in the second drive signal may alternatively be in high level time periods of each cycle of the first drive signal. Alternatively, the N drive pulses in the second drive signal may be divided into a first part of drive pulses and a second part of drive pulses. The first part of drive pulses may be in low level time periods of each cycle of the first drive signal, and the second part of drive pulses may be in high level time periods of each cycle of the first drive signal. This is not limited in this application.

In another possible implementation, the N drive pulses in the fourth drive signal may be divided into a first part of drive pulses and a second part of drive pulses. The first part of drive pulses may be in low level time periods of each cycle of the third drive signal, and the second part of drive pulses may be in high level time periods of each cycle of the third drive signal.

Certainly, the N drive pulses in the fourth drive signal may be all in low level time periods of each cycle of the third drive signal, or may be all in high level time periods of each cycle of the third drive signal. This is not limited in this application.

Further, a frequency corresponding to each of the N drive pulses in the second drive signal or the fourth drive signal is different.

Optionally, a pulse width of each of the N drive pulses in the second drive signal or the fourth drive signal may be the same.

It should be noted that there is no correspondence between pulse widths and frequencies that are of different drive pulses of the N drive pulses in the second drive signal or the fourth drive signal. That is, when pulse widths of different drive pulses are the same, frequencies of the different drive pulses may be the same or different. Similarly, when frequencies of different drive pulses are the same, pulse widths of the different drive pulses may be the same or different.

In a possible implementation, a lag time in this application may be defined in the following two manners:
Manner 1: In each cycle of the first drive signal, a time between a rising edge of the first drive signal and the rising edge of the first drive pulse of the N drive pulses in the second drive signal may be a lag time.
Manner 2: In each cycle of the third drive signal, a time between the rising edge of the third drive signal and the rising edge of the first drive pulse of the N drive pulses in the fourth drive signal may be a lag time.

Certainly, the lag time may alternatively be defined in another manner. This is not limited in this application.

The following describes in detail an obtaining process of the lag time.

In an example, because a ripple current of the inductor is affected by the lag time, the controller may obtain the lag time based on the ripple current of the inductor. To reduce the ripple current of the inductor, in each charging and discharging cycle of the inductor, the controller may control a charging current of the inductor to be equal to a discharging current of the inductor to obtain the lag time.

Further, in each charging and discharging cycle of the inductor, the controller may control the charging current of the inductor to be equal to the discharging current of the inductor to obtain the lag time.

Further, the controller may obtain the lag time based on a first voltage of the bidirectional direct current converter, a second voltage of the bidirectional direct current converter, the voltage of the capacitor, and the cycle of the first drive signal/the third drive signal.

Optionally, the first voltage may be used to indicate an input voltage of the bidirectional direct current converter, and the second voltage may be used to indicate an output voltage of the bidirectional direct current converter. Alternatively, the first voltage may be used to indicate an output voltage of the bidirectional direct current converter, and the second voltage may be used to indicate an input voltage of the bidirectional direct current converter.

Specifically, the controller may obtain the lag time (D₁+D₂)T_{sw} according to the following formula: $\left({V}_{1}+{V}_{c}-{V}_{2}\right) {D}_{1} {T}_{sw} = \left({V}_{2}-{V}_{1}\right) {D}_{2} {T}_{sw}$

In the formula, V₁ may represent the first voltage of the bidirectional direct current converter, V₂ may represent the second voltage of the bidirectional direct current converter, V_{c} may represent the voltage of the capacitor, T_{sw} may represent the cycle of the first drive signal or the third drive signal, D₁ may represent a duty cycle of the first drive signal, and D₂T_{sw} may represent the delay time between the rising edge of the first drive pulse of the N drive pulses in the second drive signal and the falling edge of the first drive signal.

In another example, the controller may obtain the lag time based on the loss of the first switching transistor and/or the loss of the second switching transistor, or may obtain the lag time based on the loss of the third switching transistor and/or the loss of the fourth switching transistor.

That is, the controller may obtain the lag time based on only the loss of the first switching transistor, based on only the loss of the second switching transistor, or based on both the loss of the first switching transistor and the loss of the second switching transistor.

Similarly, the controller may obtain the lag time based on only the loss of the third switching transistor, based on only the loss of the fourth switching transistor, or based on both the loss of the third switching transistor and the loss of the fourth switching transistor.

In another example, the controller may obtain the lag time based on the ripple current of the inductor and the loss of at least one of the first switching transistor and the second switching transistor (namely, the loss of the first switching transistor and/or the loss of the second switching transistor), or may obtain the lag time based on the ripple current of the inductor and the loss of at least one of the third switching transistor and the fourth switching transistor (namely, the loss of the third switching transistor and/or the loss of the fourth switching transistor).

It should be noted that the lag time may alternatively be obtained by using another process in this application. This is not limited in this application.

In this application, a loss generated by the bidirectional direct current converter may be reduced based on losses of different switching transistors, thereby improving conversion efficiency of the bidirectional direct current converter.

In a possible implementation, the bidirectional direct current converter provided in this application may further include a fifth switching transistor. A first terminal of the fifth switching transistor may be configured to connect to the second terminal of the capacitor, and a second terminal of the fifth switching transistor may be configured to connect to the second node.

Optionally, the fifth switching transistor may use an insulated gate field-effect transistor, an insulated gate bipolar transistor, a bidirectional switch, or the like. Certainly, the fifth switching transistor may alternatively use another type of controllable power device. A type of the fifth switching transistor is not limited in this application.

In this application, the fifth switching transistor is turned on and off, to protect the second switching transistor from being damaged due to excessively large voltage stress.

In another possible implementation, considering pre-charging of the capacitor and an abrupt change of a voltage of a bus in the bidirectional direct current converter, the bidirectional direct current converter provided in this application may further include a first diode and a second diode.

Optionally, an anode of the first diode may be configured to connect to the second node, a cathode of the first diode may be configured to connect to a midpoint of the second voltage, an anode of the second diode may be configured to connect to the midpoint of the second voltage, and a cathode of the second diode may be configured to connect to the third node.

It may be understood that a function of the first diode is to clamp a voltage drop borne by the second switching transistor, to prevent the second switching transistor from bearing a voltage of an entire direct current bus when the fourth switching transistor is turned on. Similarly, a function of the second diode is to clamp a voltage drop borne by the fourth switching transistor, to prevent the fourth switching transistor from bearing a voltage of an entire direct current bus when the second switching transistor is turned on. Therefore, the first diode and the second diode may be referred to as clamping diodes.

Further, the first switching transistor, the second switching transistor, the third switching transistor, and the fourth switching transistor separately use any one of the insulated gate field-effect transistor, the insulated gate bipolar transistor, and the bidirectional switch.

Optionally, the first diode and the second diode each may alternatively be replaced with another type of power device. In this case, the controller only needs to send corresponding drive signals, so that the switching transistors implement working modes of the diodes. Details are not described in this application again.

According to a second aspect not covered by the scope of the appended claims, this application provides an electronic device. The electronic device may include a bidirectional direct current converter. For detailed descriptions of the bidirectional direct current converter, refer to the foregoing descriptions. Details are not described in this application again.

According to a third aspect, this application provides a control method of a bidirectional direct current converter. The bidirectional direct current converter includes a first switching transistor, a second switching transistor, a third switching transistor, a fourth switching transistor, a capacitor, an inductor, and a controller.

The bidirectional direct current converter includes a first direct current terminal, a second direct current terminal, a third direct current terminal, and a fourth direct current terminal.

In an example, the first direct current terminal and the second direct current terminal may constitute an input terminal of the bidirectional direct current converter, and the third direct current terminal and the fourth direct current terminal may constitute an output terminal of the bidirectional direct current converter. Therefore, the bidirectional direct current converter may implement forward power transmission by using the four direct current terminals.

In another example, the third direct current terminal and the fourth direct current terminal may constitute an input terminal of the bidirectional direct current converter, and the first direct current terminal and the second direct current terminal may constitute an output terminal of the bidirectional direct current converter. Therefore, the bidirectional direct current converter may implement reverse power transmission by using the four direct current terminals.

Further, a first terminal of the inductor is configured to connect to the first direct current terminal, and a second terminal of the inductor is configured to connect to a first node. A first electrode of the first switching transistor is configured to connect to the first node, and a second electrode of the first switching transistor is configured to connect to a second node. A first electrode of the second switching transistor is configured to connect to the second node, and a second electrode of the second switching transistor is configured to connect to the second direct current terminal and the fourth direct current terminal. A first electrode of the third switching transistor is configured to connect to the first node, and a second electrode of the third switching transistor is configured to connect to a third node. A first electrode of the fourth switching transistor is configured to connect to the third node, and a second electrode of the fourth switching transistor is configured to connect to the third direct current terminal. A first terminal of the capacitor is configured to connect to the third node, and a second terminal of the capacitor is configured to connect to the second node. The controller is configured to connect to the first switching transistor, the second switching transistor, the third switching transistor, and the fourth switching transistor.

Therefore, the control method of the bidirectional direct current converter includes: The controller performs complementary control on the first switching transistor and the third switching transistor, and performs complementary control on the second switching transistor and the fourth switching transistor.

The complementary control is used to indicate that two switching transistors in complementary control cannot be simultaneously turned on or off. For example, the first switching transistor and the third switching transistor cannot be simultaneously turned on or off, and the second switching transistor and the fourth switching transistor cannot be simultaneously turned on or off.

The controller controls a quantity of on times of the second switching transistor to be greater than a quantity of on times of the first switching transistor in a same cycle. It may also be understood as that, in one cycle, the controller may control a switching frequency of the second switching transistor to be greater than a switching frequency of the first switching transistor, thereby reducing losses of the first switching transistor and the second switching transistor.

In the control method provided in this application, the controller controls the quantity of on times of the second switching transistor to be different from the quantity of on times of the first switching transistor in a same cycle. This can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, in any cycle of the first switching transistor, there may be a delay between an on moment of the first switching transistor and an on moment of the second switching transistor. That is, the first switching transistor and the second switching transistor are not simultaneously turned on in any cycle.

Further, a cycle of the first switching transistor may be the same as a cycle of the third switching transistor.

In a possible implementation, the control method may further include: The controller controls a quantity of on times of the fourth switching transistor to be greater than a quantity of on times of the third switching transistor in a same cycle. It may also be understood as that, in one cycle, the controller may control a switching frequency of the fourth switching transistor to be greater than a switching frequency of the third switching transistor, thereby reducing losses of the third switching transistor and the fourth switching transistor.

It may be understood that the controller controls the quantity of on times of the fourth switching transistor to be different from the quantity of on times of the third switching transistor in a same cycle. Similarly, this can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

It should be understood that technical solutions of the second aspect and the third aspect of this application are consistent with the technical solution of the first aspect of this application, and beneficial effects obtained by the aspects and corresponding feasible implementations are similar. Details are not described herein again.

### BRIEF DESCRIPTION OF DRAWINGS

To describe the technical solutions in this application or in the conventional technology more clearly, the following briefly describes the accompanying drawings for describing implementations or the conventional technology. It is clear that the accompanying drawings in the following description show some implementations of this application, and a person of ordinary skill in the art may still derive other drawings from these accompanying drawings without creative efforts.
FIG. 1 is a schematic diagram of a structure of a bidirectional direct current converter according to an implementation of this application;
FIG. 2 is a schematic diagram of waveforms of asymmetric drive signals according to an implementation of this application;
FIG. 3 is a schematic diagram of waveforms of symmetric drive signals according to an implementation of this application;
FIG. 4 is a schematic diagram of waveforms of symmetric drive signals according to an implementation of this application;
FIG. 5 is a schematic diagram of waveforms of a first drive signal and a second drive signal according to an implementation of this application;
FIG. 6 is a schematic diagram of waveforms of a first drive signal and a second drive signal according to an implementation of this application;
FIG. 7 is a schematic diagram of waveforms of a first drive signal and a second drive signal according to an implementation of this application;
FIG. 8 is a schematic diagram of waveforms of a first drive signal and a second drive signal according to an implementation of this application;
FIG. 9 is a schematic diagram of waveforms of a first drive signal and a second drive signal according to an implementation of this application;
FIG. 10 is a schematic diagram of waveforms of a first drive signal and a second drive signal according to an implementation of this application;
FIG. 11 is a schematic diagram of waveforms of a first drive signal and a second drive signal according to an implementation of this application;
FIG. 12 is a schematic diagram of waveforms of a first drive signal and a second drive signal according to an implementation of this application;
FIG. 13 is a schematic diagram of a structure of a bidirectional direct current converter according to an implementation of this application;
FIG. 14 is a schematic diagram of a structure of a bidirectional direct current converter according to an implementation of this application; and
FIG. 15 is a schematic diagram of a structure of a bidirectional direct current converter according to an implementation of this application.

### DESCRIPTION OF IMPLEMENTATIONS

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those that comprise at least all the features of an independent claim. Any implementation that does not fall within the scope of the claims does not form part of the invention, but rather included as an illustrative example that is useful for understanding the invention.

The terms "first", "second", and the like in the specification implementations, claims, and accompanying drawings of this application are merely used for distinguishing descriptions, and cannot be understood as indicating or implying relative importance, or as indicating or implying a sequence. In addition, the terms "include", "have", and any variation thereof are intended to cover non-exclusive inclusions, for example, a series of steps or units are included. Methods, systems, products, or devices are not limited to those clearly listed steps or units, and other steps or units that are not clearly listed or that are inherent to these processes, methods, products, or devices may be included.

It should be understood that, in this application, "at least one (item)" refers to one or more, and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. "At least one of the following items (pieces)" or a similar expression thereof indicates any combination of these items, including a single item (piece) or any combination of a plurality of items (pieces). For example, at least one item (piece) of a, b, or c may represent: a, b, c, "a and b", "a and c", "b and c", or "a, b, and c", where a, b, and c may be singular or plural.

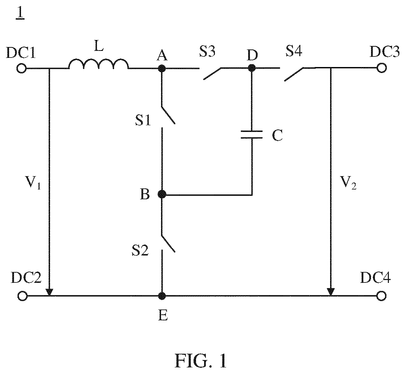

An implementation of this application provides a bidirectional direct current converter, as shown in FIG. 1. In FIG. 1, the bidirectional direct current converter 1 may include a first switching transistor S1, a second switching transistor S2, a third switching transistor S3, a fourth switching transistor S4, a capacitor C (flying capacitor), an inductor L, and a controller (not shown in FIG. 1).

Optionally, the bidirectional direct current converter 1 may include a first direct current terminal DC1, a second direct current terminal DC2, a third direct current terminal DC3, and a fourth direct current terminal DC4.

In an example, the first direct current terminal DC1 and the second direct current terminal DC2 may constitute an input terminal of the bidirectional direct current converter 1, and the third direct current terminal DC3 and the fourth direct current terminal DC4 may constitute an output terminal of the bidirectional direct current converter 1. Therefore, in FIG. 1, V₁ (namely, a first voltage that is a voltage between the first direct current terminal DC1 and the second direct current terminal DC2) may be used to indicate an input voltage of the bidirectional direct current converter 1, and V₂ (namely, a second voltage that is a voltage between the third direct current terminal DC3 and the fourth direct current terminal DC4) may be used to indicate an output voltage of the bidirectional direct current converter 1.

In another example, the third direct current terminal DC3 and the fourth direct current terminal DC4 may constitute an input terminal of the bidirectional direct current converter 1, and the first direct current terminal DC1 and the second direct current terminal DC2 may constitute an output terminal of the bidirectional direct current converter 1. Therefore, in FIG. 1, V₁ (namely, a first voltage) may be used to indicate an output voltage of the bidirectional direct current converter 1, and V₂ (namely, a second voltage) may be used to indicate an input voltage of the bidirectional direct current converter 1.

It can be learned that the bidirectional direct current converter provided in this implementation of this application can implement bidirectional power transmission. To be specific, a power may be transmitted from the first direct current terminal DC1 and the second direct current terminal DC2 that are used as the input terminal to the third direct current terminal DC3 and the fourth direct current terminal DC4 that are used as the output terminal, to implement forward power transmission (that is, the bidirectional direct current converter performs forward working).

Similarly, a power may alternatively be transmitted from the third direct current terminal DC3 and the fourth direct current terminal DC4 that are used as the input terminal to the first direct current terminal DC1 and the second direct current terminal DC2 that are used as the output terminal, to implement reverse power transmission (that is, the bidirectional direct current converter performs reverse working).

A first terminal of the inductor L (namely, a left terminal of the inductor L in FIG. 1) may be connected to the first direct current terminal DC1, and a second terminal of the inductor L may be connected to a node A (namely, a first node). A first electrode of the first switching transistor S1 (namely, an electrode that is of the first switching transistor S1 and that is close to the node A in FIG. 1) may be connected to the node A, and a second electrode of the first switching transistor S1 (namely, an electrode that is of the first switching transistor S1 and that is close to a node B in FIG. 1) may be connected to the node B (namely, a second node). A first electrode of the second switching transistor S2 (namely, an electrode that is of the second switching transistor S2 and that is close to the node B in FIG. 1) is connected to the node B, a second electrode of the second switching transistor S2 (namely, an electrode that is of the second switching transistor S2 and that is away from the node B in FIG. 1) may be connected to a node E, and the node E is connected to the second direct current terminal DC2 and the fourth direct current terminal DC4. A first electrode of the third switching transistor S3 (namely, an electrode that is of the third switching transistor S3 and that is close to the node A in FIG. 1) may be connected to the node A, and a second electrode of the third switching transistor S3 (namely, an electrode that is of the third switching transistor S3 and that is close to a node D in FIG. 1) is connected to the node D (namely, a third node). A first electrode of the fourth switching transistor S4 (namely, an electrode that is of the fourth switching transistor S4 and that is close to the node D in FIG. 1) is connected to the node D, and a second electrode of the fourth switching transistor S4 (namely, an electrode that is of the fourth switching transistor S4 and that is close to the third direct current terminal DC3 in FIG. 1) may be connected to the third direct current terminal DC3. A first terminal of the capacitor C (which may be a positive terminal of the capacitor C) may be connected to the node D, and a second terminal of the capacitor C (which may be a negative terminal of the capacitor C) may be connected to the node B. The controller may be connected to the first switching transistor S1, the second switching transistor S2, the third switching transistor S3, and the fourth switching transistor S4.

It can be learned from the foregoing connection relationship that the bidirectional direct current converter provided in this implementation of this application is a three-level direct current converter, and three levels are implemented by using a topology of the bidirectional direct current converter. In addition, voltage stress of a power device may be reduced, so that a high-level voltage output can be implemented by using a power device with a low withstand voltage level.

The controller is configured to: perform complementary control on the first switching transistor S1 and the third switching transistor S3, and perform complementary control on the second switching transistor S2 and the fourth switching transistor S4.

The complementary control is used to indicate that two switching transistors in complementary control cannot be simultaneously turned on or off. For example, the first switching transistor S1 and the third switching transistor S3 cannot be simultaneously turned on or off, and the second switching transistor S2 and the fourth switching transistor S4 cannot be simultaneously turned on or off.

That is, the controller controls the first switching transistor S1 and the third switching transistor S3 not to be simultaneously turned on or off, and the controller further controls the second switching transistor S2 and the fourth switching transistor S4 not to be simultaneously turned on or off.

Further, the controller may be further configured to control a quantity of on times of the second switching transistor S2 to be greater than a quantity of on times of the first switching transistor S1 in a same cycle. It may also be understood as that, in one cycle, the controller may control a switching frequency of the second switching transistor S2 to be greater than a switching frequency of the first switching transistor S1, thereby reducing losses of the first switching transistor S1 and the second switching transistor S2.

In this implementation of this application, the controller may control the quantity of on times of the second switching transistor to be different from the quantity of on times of the first switching transistor in a same cycle. This can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, in any cycle of the first switching transistor S1, there may be a delay between an on moment of the first switching transistor S1 and an on moment of the second switching transistor S2. That is, the first switching transistor S1 and the second switching transistor S2 are not simultaneously turned on in any cycle.

Further, a cycle of the first switching transistor S1 may be the same as a cycle of the third switching transistor S3.

In a possible implementation, the controller may be further configured to control a quantity of on times of the fourth switching transistor S4 to be greater than a quantity of on times of the third switching transistor S3 in a same cycle. It may also be understood as that, in one cycle, the controller may control a switching frequency of the fourth switching transistor S4 to be greater than a switching frequency of the third switching transistor S3, thereby reducing losses of the fourth switching transistor S4 and the third switching transistor S3.

It may be understood that the controller controls the quantity of on times of the fourth switching transistor to be different from the quantity of on times of the third switching transistor in a same cycle. Similarly, this can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, the controller may send a first drive signal (which may be represented by PWM (pulse width modulation, that is, pulse width modulation) 1) to the first switching transistor S1, send a second drive signal (which may be represented by PWM2) to the second switching transistor S2, send a third drive signal (which may be represented by PWM3) to the third switching transistor S3, and send a fourth drive signal (which may be represented by PWM4) to the fourth switching transistor S4.

Optionally, a cycle (namely, each cycle) of the first drive signal PWM1 and a cycle (namely, each cycle) of the third drive signal PWM3 are the same, and may be both represented by *T_{sw}* (that is, *T_{sw}* represents the cycle of the first drive signal PWM1 or the third drive signal PWM3).

The second drive signal PWM2 has N drive pulses in each cycle of the first drive signal PWM1, that is, the second drive signal PWM2 and the first drive signal PWM1 are two asymmetric drive signals.

Similarly, the fourth drive signal PWM4 also has N drive pulses in each cycle of the third drive signal PWM3, that is, the fourth drive signal PWM4 and the third drive signal PWM3 are two asymmetric drive signals.

Because the second drive signal PWM2 may have N drive pulses in each cycle of the first drive signal PWM1, a cycle of the second drive signal PWM2 is different from the cycle of the first drive signal PWM1. Similarly, because the fourth drive signal PWM4 may also have N drive pulses in each cycle of the third drive signal PWM3, a cycle of the fourth drive signal PWM4 is also different from the cycle of the third drive signal PWM3.

The controller sends the first drive signal PWM1 to the first switching transistor S1, to control on and off of the first switching transistor S1. It may be understood that the first drive signal PWM1 may be used to indicate the first switching transistor S1 to be turned on, or the first drive signal PWM1 may be used to indicate the first switching transistor S1 to be turned off.

Similarly, the controller sends the second drive signal PWM2 to the second switching transistor S2, to control on and off of the second switching transistor S2. It may be understood that the second drive signal PWM2 may be used to indicate the second switching transistor S2 to be turned on, or the second drive signal PWM2 may be used to indicate the second switching transistor S2 to be turned off.

The controller sends the third drive signal PWM3 to the third switching transistor S3, to control on and off of the third switching transistor S3. It may be understood that the third drive signal PWM3 may be used to indicate the third switching transistor S3 to be turned on, or the third drive signal PWM3 may be used to indicate the third switching transistor S3 to be turned off.

The controller sends the fourth drive signal PWM4 to the fourth switching transistor S4, to control on and off of the fourth switching transistor S4. It may be understood that the fourth drive signal PWM4 may be used to indicate the fourth switching transistor S4 to be turned on, or the fourth drive signal PWM4 may be used to indicate the fourth switching transistor S4 to be turned off.

The inductor L has N+1 charging and discharging cycles in each cycle (namely, *T_{sw}*) of the first drive signal PWM1 or the third drive signal PWM3, where N is an integer greater than or equal to 3. A value of N is not limited in this implementation of this application.

Therefore, the inductor L has at least three charging and discharging cycles in each cycle T_{sw}. The controller increases a charging and discharging frequency of the inductor L in each cycle T_{sw} (namely, frequency increase), thereby reducing the inductance of the inductor L, and reducing the size and the costs of the inductor L.

For example, when N is equal to 2, the inductor L may have three charging and discharging cycles in each cycle T_{sw}; and when N is equal to 3, the inductor L may have four charging and discharging cycles in each cycle T_{sw}.

For ease of description, the following uses N=2 as an example for detailed description.

FIG. 2 is a schematic diagram of waveforms of four drive signals (namely, the first drive signal PWM1 (dashed line), the second drive signal PWM2 (dashed line), the third drive signal PWM3 (solid line), and the fourth drive signal PWM4 (solid line)). In FIG. 2, i_{L} represents an actual current (solid line) of the inductor L, and I_{Lavg} may represent an average current (dashed line) of the inductor L.

Optionally, when the first drive signal PWM1 is at a high level, the first switching transistor S1 may be turned on; and when the first drive signal PWM1 is at a low level, the first switching transistor S1 may be turned off.

Similarly, when the third drive signal PWM3 is at a high level, the third switching transistor S3 may be turned on; and when the third drive signal PWM3 is at a low level, the third switching transistor S3 may be turned off.

It may be understood that the first drive signal PWM1 may be complementary to the third drive signal PWM3. That is, when the first drive signal PWM1 is at a high level, the third drive signal PWM3 may be at a low level. Similarly, when the first drive signal PWM1 is at a low level, the third drive signal PWM3 may be at a high level.

It should be noted that there is a delay interval (namely, T_{delay1} in FIG. 2) between a falling edge of the first drive signal PWM1 and a rising edge of the third drive signal PWM3. That is, in a range of the delay interval T_{delay1}, the first switching transistor S1 and the third switching transistor S3 are simultaneously turned off.

Optionally, when the second drive signal PWM2 is at a high level, the second switching transistor S2 may be turned on; and when the second drive signal PWM2 is at a low level, the second switching transistor S2 may be turned off.

Similarly, when the fourth drive signal PWM2 is at a high level, the fourth switching transistor S4 may be turned on; and when the fourth drive signal PWM4 is at a low level, the fourth switching transistor S4 may be turned off.

It may be understood that the second drive signal PWM2 may be complementary to the fourth drive signal PWM4. That is, when the second drive signal PWM2 is at a high level, the fourth drive signal PWM4 may be at a low level. Similarly, when the second drive signal PWM2 is at a low level, the fourth drive signal PWM4 may be at a high level.

It should be noted that there is also a delay interval (namely, T_{delay2} in FIG. 2) between a falling edge of a first drive pulse of the N drive pulses in the fourth drive signal PWM4 and a rising edge of a first drive pulse of the N drive pulses in the second drive signal PWM2. In a range of the delay interval T_{delay2}, the second switching transistor S2 and the fourth switching transistor S4 are simultaneously turned off.

In a possible implementation, in any cycle of the first switching transistor S1, there may be a delay between the on moment of the first switching transistor S1 and the on moment of the second switching transistor S2. Therefore, in each cycle of the first drive signal PWM1, the rising edge of the first drive pulse of the N drive pulses in the second drive signal PWM2 may be behind the falling edge of the first drive signal PWM1. That is, there is a delay time (namely, a delay) between a first drive pulse of two drive pulses in the second drive signal PWM2 and the first drive signal PWM1.

Similarly, in each cycle of the third drive signal PWM3, a rising edge of the first drive pulse of the N drive pulses in the fourth drive signal PWM4 may be in front of a falling edge of the third drive signal PWM3. That is, there is a delay between a first drive pulse of two drive pulses in the fourth drive signal PWM4 and the third drive signal PWM3.

In the following, the third direct current terminal DC3 and the fourth direct current terminal DC4 in FIG. 1 are used as the input terminal of the bidirectional direct current converter, and the first direct current terminal DC1 and the second direct current terminal DC2 are used as the output terminal of the bidirectional direct current converter, to describe a control process of the controller for the four switching transistors. When the bidirectional direct current converter performs reverse working, the bidirectional direct current converter is a buck converter.

In FIG. 2, a time period F11, a time period F12, a time period F13, a time period F14, a time period F15, and a time period F16 are different time periods of one cycle T_{sw} of the first drive signal PWM1. The six time periods (namely, the time period F11, the time period F12, the time period F13, the time period F14, the time period F15, and the time period F16) constitute one cycle T_{sw} of the first drive signal PWM1.

It can be seen from FIG. 2 that, in each cycle of the first drive signal PWM1, a rising edge of the first drive pulse of the two drive pulses in the second drive signal PWM2 may be behind the falling edge of the first drive signal PWM1. That is, there is a delay time (namely, a delay) between the first drive pulse of the two drive pulses in the second drive signal PWM2 and the first drive signal PWM1.

Optionally, the second drive signal PWM2 may have two drive pulses in each cycle T_{sw} of the first drive signal PWM1, and the second drive signal PWM2 has two drive pulses in low level time periods of each cycle T_{sw} of the first drive signal PWM1. Therefore, in one cycle T_{sw} of the first drive signal PWM1, the inductor L has three charging and discharging cycles in total, that is, the inductor L completes three times of charging and discharging in one cycle T_{sw} of the first drive signal PWM1. This increases the charging and discharging frequency of the inductor L.

One cycle T_{sw} of the first drive signal PWM1 may be used as an example. The time period F11 is a high level time period of the first drive signal PWM1, and the time period F12, the time period F13, the time period F14, the time period F15, and the time period F16 each are a low level time period of the first drive signal PWM1.

The second drive signal PWM2 has drive pulses in the time period F13 and the time period F15, that is, the second drive signal PWM2 is at a high level in the time period F13 and the time period F15. The second drive signal PWM2 does not have a drive pulse in the time period F11, the time period F12, the time period F14, and the time period F16, that is, the second drive signal PWM2 is at a low level in the time period F11, the time period F12, the time period F14, and the time period F16.

That is, the second drive signal PWM2 has two drive pulses in the low level time periods of one cycle T_{sw} of the first drive signal PWM1, that is, a drive pulse corresponding to the time period F13 and a drive pulse corresponding to the time period F15. Therefore, the inductor L completes charging and discharging in the time period F11 and the time period F12 for the first time, completes charging and discharging in the time period F13 and the time period F14 for the second time, and completes charging and discharging in the time period F15 and the time period F16 for the third time. It can be learned that the inductor L completes charging and discharging for three times in total. This increases the charging and discharging frequency of the inductor L in one cycle T_{sw} of the first drive signal PWM1, and further reduces a ripple current in the inductor L.

The following describes in detail, with reference to FIG. 2, that the controller controls the second drive signal PWM2 to have two drive pulses in the low level time periods of each cycle T_{sw} of the first drive signal PWM1 to increase the charging and discharging frequency of the inductor L.

For ease of description, the following uses one cycle T_{sw} of the first drive signal PWM1 as an example to describe a charging and discharging process of the inductor L.

As shown in FIG. 2, in the time period F11, the first drive signal PWM1 is at a high level, and the second drive signal PWM2 is at a low level. To be specific, the controller may control the first switching transistor S1 to be turned on and control the second switching transistor S2 to be turned off, so that the inductor L is discharged, and i_{L} gradually decreases. In the time period F12, both the first drive signal PWM1 and the second drive signal PWM2 are at a low level. To be specific, the controller may control both the first switching transistor S1 and the second switching transistor S2 to be turned off, so that the inductor L is charged, and i_{L} gradually increases. In this case, the inductor L completes charging and discharging for the first time.

In the time period F13, the first drive signal PWM1 is at a low level, and the second drive signal PWM2 is at a high level. To be specific, the controller may control the first switching transistor S1 to be turned off and control the second switching transistor S2 to be turned on, so that the inductor L is discharged, and i_{L} gradually decreases. In the time period F14, both the first drive signal PWM1 and the second drive signal PWM2 are at a low level. To be specific, the controller may control both the first switching transistor S1 and the second switching transistor S2 to be turned off, so that the inductor L is charged, and i_{L} gradually increases. In this case, the inductor L completes charging and discharging for the second time.

In the time period F15, the first drive signal PWM1 is at a low level, and the second drive signal PWM2 is at a high level. To be specific, the controller may control the first switching transistor S1 to be turned off and control the second switching transistor S2 to be turned on, so that the inductor L is discharged, and i_{L} gradually decreases. In the time period F16, both the first drive signal PWM1 and the second drive signal PWM2 are at a low level. To be specific, the controller may control both the first switching transistor S1 and the second switching transistor S2 to be turned off, so that the inductor L is charged, and i_{L} gradually increases. In this case, the inductor L completes charging and discharging for the third time.

Therefore, the inductor L completes charging and discharging for three times in total in one cycle T_{sw} of the first drive signal PWM1.

The controller sends the first drive signal PWM1 and the second drive signal PWM2 that are asymmetric to the first switching transistor S1 and the second switching transistor S2, to increase the quantity of charging and discharging times of the inductor L in each cycle of the first drive signal PWM1, that is, increase the charging and discharging frequency of the inductor L. Therefore, the inductor with a small inductance may be used while a same ripple current percentage of the inductor L is ensured. In addition, the inductor with a small inductance has a small size and low costs. This can reduce a size and costs of the bidirectional direct current converter.

Still refer to FIG. 2. A time period F21, a time period F22, a time period F23, a time period F24, a time period F25, and a time period F26 are different time periods of one cycle T_{sw} of the third drive signal PWM3. The six time periods (namely, the time period F21, the time period F22, the time period F23, the time period F24, the time period F25, and the time period F26) constitute one cycle T_{sw} of the third drive signal PWM3.

It can be further seen from FIG. 2 that, in each cycle of the third drive signal PWM3, a rising edge of the first drive pulse of the two drive pulses in the fourth drive signal PWM4 may be in front of the falling edge of the third drive signal PWM3. That is, there is also a delay between the first drive pulse of the two drive pulses in the fourth drive signal PWM4 and the third drive signal PWM3.

Optionally, the fourth drive signal PWM4 may have two drive pulses in each cycle T_{sw} of the third drive signal PWM3. One of the two drive pulses in the fourth drive signal PWM4 (namely, a first part of drive pulses in a plurality of drive pulses in the fourth drive signal PWM4) is in a low level time period of each cycle T_{sw} of the third drive signal PWM3, and the other of the two drive pulses in the fourth drive signal PWM4 (namely, a second part of drive pulses in the plurality of drive pulses in the fourth drive signal PWM4) is in a high level time period of each cycle T_{sw} of the third drive signal PWM3. Therefore, in one cycle T_{sw} of the third drive signal PWM3, the inductor L has three charging and discharging cycles in total, that is, the inductor L completes three times of charging and discharging in one cycle T_{sw} of the third drive signal PWM3. Similarly, this can increase the charging and discharging frequency of the inductor L.

One cycle T_{sw} of the third drive signal PWM3 may be used as an example. The time period F21 is a low level time period of the third drive signal PWM3, and the time period F22, the time period F23, the time period F24, the time period F25, and the time period F26 each are a high level time period of the third drive signal PWM3.

The fourth drive signal PWM4 has drive pulses in the time period F21, the time period F22, the time period F24, and the time period F26, that is, the fourth drive signal PWM4 is at a high level in the time period F21, the time period F22, the time period F24, and the time period F26. The fourth drive signal PWM4 does not have a drive pulse in the time period F23 and the time period F25, that is, the fourth drive signal PWM4 is at a low level in the time period F23 and the time period F25.

That is, the fourth drive signal PWM4 has one drive pulse in a low level time period of one cycle T_{sw} of the third drive signal PWM3, namely, a drive pulse corresponding to the time period F21. In addition, the fourth drive signal PWM4 has two drive pulses in high level time periods of one cycle T_{sw} of the third drive signal PWM3, namely, a drive pulse corresponding to the time period F24 and a drive pulse corresponding to the time period F26.

Therefore, the inductor L completes charging and discharging in the time period F21 to the time period F23 for the first time, completes charging and discharging in the time period F24 and the time period F26 for the second time, and completes charging and discharging in the time period F26 for the third time. It can be learned that the inductor L completes charging and discharging for three times in total. This increases the charging and discharging frequency of the inductor L in one cycle T_{sw} of the third drive signal PWM3, and further reduces a ripple current in the inductor L.

The following describes in detail, with reference to FIG. 1, that the controller controls the fourth drive signal PWM4 to have one drive pulse in the low level time period and two drive pulses in the high level time periods of each cycle T_{sw} of the third drive signal PWM3 to increase the charging and discharging frequency of the inductor L.

For ease of description, the following uses one cycle T_{sw} of the third drive signal PWM3 as an example to describe a charging and discharging process of the inductor L.

As shown in FIG. 2, in the time period F21, the third drive signal PWM3 is at a low level, and the fourth drive signal PWM4 is at a high level. To be specific, the controller may control the third switching transistor S3 to be turned off and control the fourth switching transistor S4 to be turned on, so that the inductor L is discharged, and i_{L} gradually decreases. In the time period F22, both the third drive signal PWM3 and the fourth drive signal PWM4 are at a high level. To be specific, the controller may control both the third switching transistor S3 and the fourth switching transistor S4 to be turned on, so that the inductor L is charged, and i_{L} gradually increases. In this case, the inductor L completes charging and discharging for the first time.

In the time period F23, the third drive signal PWM3 is at a high level, and the fourth drive signal PWM4 is at a low level. To be specific, the controller may control the third switching transistor S3 to be turned on and control the fourth switching transistor S4 to be turned off, so that the inductor L is discharged, and i_{L} gradually decreases. In the time period F24, both the third drive signal PWM3 and the fourth drive signal PWM4 are at a high level. To be specific, the controller may control both the third switching transistor S3 and the fourth switching transistor S4 to be turned on, so that the inductor L is charged, and i_{L} gradually increases. In this case, the inductor L completes charging and discharging for the second time.

In the time period F25, the third drive signal PWM3 is at a high level, and the fourth drive signal PWM4 is at a low level. To be specific, the controller may control the third switching transistor S3 to be turned on and control the fourth switching transistor S4 to be turned off, so that the inductor L is discharged, and i_{L} gradually decreases. In the time period F26, both the third drive signal PWM3 and the fourth drive signal PWM4 are at a high level. To be specific, the controller may control both the third switching transistor S3 and the fourth switching transistor S4 to be turned on, so that the inductor L is charged, and i_{L} gradually increases. In this case, the inductor L completes charging and discharging for the third time.

Therefore, the inductor L completes charging and discharging for three times in total in one cycle T_{sw} of the third drive signal PWM3.

The controller sends the third drive signal PWM3 and the fourth drive signal PWM4 that are asymmetric to the third switching transistor S3 and the fourth switching transistor S4, to increase the quantity of charging and discharging times of the inductor L in each cycle of the third drive signal PWM3, that is, increase the charging and discharging frequency of the inductor L. Therefore, the inductor with a small inductance may be used while a same ripple current percentage of the inductor L is ensured. In addition, the inductor with a small inductance has a small size and low costs. This can reduce a size and costs of the bidirectional direct current converter.

In the bidirectional direct current converter provided in this implementation of this application, the controller can send the asymmetric drive signals to the first switching transistor and the second switching transistor, and send the asymmetric drive signals to the third switching transistor and the fourth switching transistor. This increases the charging and discharging frequency of the inductor, thereby reducing the costs of the inductor, and further reducing the size and the costs of the bidirectional direct current converter. When the size of the bidirectional direct current converter is reduced, power density of the bidirectional direct current converter can be increased.

In addition, in this implementation of this application, the asymmetric drive signals are sent to the first switching transistor and the second switching transistor, and the asymmetric drive signals are sent to the third switching transistor and the fourth switching transistor, so that a state of the first switching transistor is opposite to a state of the third switching transistor (that is, the first switching transistor is complementary to the third switching transistor), and a state of the second switching transistor is opposite to a state of the fourth switching transistor (that is, the second switching transistor is complementary to the fourth switching transistor). Further, current sharing or complement is implemented between a branch in which the first switching transistor and the second switching transistor are located and a branch in which the third switching transistor and the fourth switching transistor are located (that is, between two branches), so that a voltage of the capacitor remains stable.

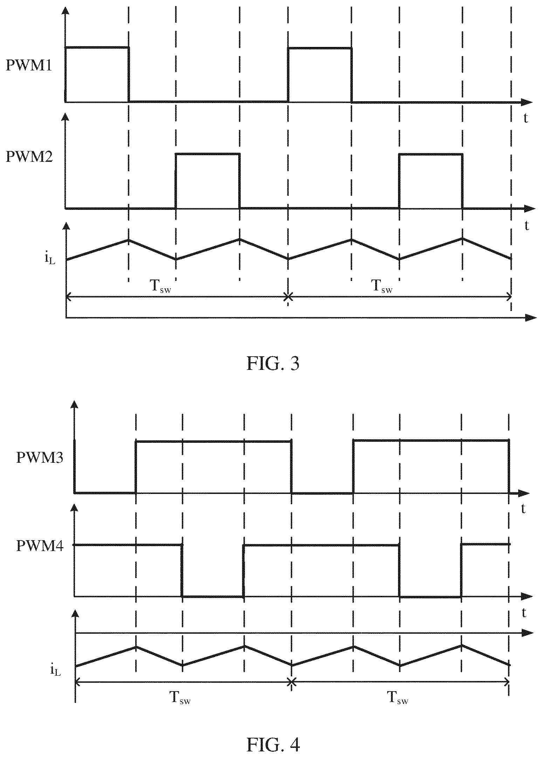

To verify advantages of the asymmetric drive signals shown in FIG. 2, the following performs description with reference to diagrams of waveforms of symmetric drive signals provided in FIG. 3 and FIG. 4.

When the bidirectional direct current converter shown in FIG. 1 performs forward working (to be specific, the first direct current terminal DC1 and the second direct current terminal DC2 are used as the input terminal of the bidirectional direct current converter, and the third direct current terminal DC3 and the fourth direct current terminal DC4 are used as the output terminal of the bidirectional direct current converter), the bidirectional direct current converter is a boost converter. Therefore, the third switching transistor S3 and the fourth switching transistor S4 in the bidirectional direct current converter shown in FIG. 1 may be separately equivalent to a diode. In this case, the controller may send drive signals to only the first switching transistor S1 and the second switching transistor S2.

A diagram of waveforms of the first drive signal PWM1 sent by the controller to the first switching transistor S1 and the second drive signal PWM2 sent by the controller to the second switching transistor S2 is shown in FIG. 3. It can be seen from FIG. 3 that the first drive signal PWM1 and the second drive signal PWM2 are symmetric, that is, cycles of the two drive signals are the same, and duty cycles are also the same.

It can be seen from FIG. 3 that, in one cycle T_{sw} of the first drive signal PWM1, the first drive signal PWM1 may have one drive pulse, the second drive signal PWM2 may also have one drive pulse, and the inductor L may perform charging and discharging for two times. i_{L} has two cycles. To be specific, when the first drive signal PWM1 or the second drive signal PWM2 is at a high level, the inductor L is charged, and i_{L} gradually increases; and when the first drive signal PWM1 or the second drive signal PWM2 is at a low level, the inductor L is discharged, and i_{L} gradually decreases.

However, in FIG. 2, the first drive signal PWM1 and the second drive signal PWM2 are asymmetric drive signals. In one cycle T_{sw} of the first drive signal PWM1, the first drive signal PWM1 has one drive pulse, the second drive signal PWM2 has at least two drive pulses, and the inductor L performs charging and discharging for at least three times.

It can be learned from comparison between FIG. 2 and FIG. 3 that, in this implementation of this application, the asymmetric drive signals can be used to increase a frequency of one (namely, the second drive signal) of the drive signals, thereby increasing the charging and discharging frequency of the inductor L and reducing the inductance of the inductor.

When the bidirectional direct current converter shown in FIG. 1 performs reverse working (to be specific, the third direct current terminal DC3 and the fourth direct current terminal DC4 are used as the input terminal of the bidirectional direct current converter, and the first direct current terminal DC1 and the second direct current terminal DC2 are used as the output terminal of the bidirectional direct current converter), the bidirectional direct current converter is a buck converter. Therefore, the first switching transistor S1 and the second switching transistor S2 in the bidirectional direct current converter shown in FIG. 1 may be separately equivalent to a diode. In this case, the controller may send drive signals to only the third switching transistor S3 and the fourth switching transistor S4.

A diagram of waveforms of the third drive signal PWM3 sent by the controller to the third switching transistor S3 and the fourth drive signal PWM4 sent by the controller to the fourth switching transistor S4 is shown in FIG. 4. It can be seen from FIG. 4 that the third drive signal PWM3 and the fourth drive signal PWM4 are symmetric, that is, cycles of the two drive signals are the same, and duty cycles are also the same.

It can be seen from FIG. 4 that, in one cycle T_{sw} of the third drive signal PWM3, the third drive signal PWM3 may have one drive pulse, and the fourth drive signal PWM4 may also have one drive pulse. i_{L} has two cycles. To be specific, the inductor L may perform two times of charging and discharging as follows: When the third drive signal PWM3 is at a low level and the fourth drive signal PWM4 is at a high level, the inductor L is charged for the first time and i_{L} gradually increases, when both the third drive signal PWM3 and the fourth drive signal are at a high level, the inductor L is discharged for the first time and i_{L} gradually decreases, and the inductor L completes charging and discharging for the first time; and when the third drive signal is at a high level and the fourth drive signal PWM4 is at a low level, the inductor L is charged for the second time and i_{L} gradually increases, when the third drive signal is at a low level and the fourth drive signal PWM4 is at a low level, the inductor L is discharged for the second time and i_{L} gradually decreases, and the inductor L completes charging and discharging for the second time.

It can be learned from comparison between FIG. 2 and FIG. 4 that, in this implementation of this application, the asymmetric drive signals can be used to increase a frequency of one (namely, the fourth drive signal) of the drive signals, thereby increasing the charging and discharging frequency of the inductor L and reducing the inductance of the inductor.

The foregoing describes that the controller sends the asymmetric drive signals to the first switching transistor S1 and the second switching transistor S2, and sends the asymmetric drive signals to the third switching transistor S3 and the fourth switching transistor S4, to reduce the inductance of the inductor L, thereby reducing the size and the costs of the inductor L, and further reducing the size and the costs of the entire bidirectional direct current converter.

Optionally, the first switching transistor S1, the second switching transistor S2, the third switching transistor S3, and the fourth switching transistor S4 in FIG. 1 may separately use an insulated gate field-effect transistor (metal-oxide-semiconductor field-effect transistor, MOSFET, MOS transistor for short), an insulated gate bipolar transistor (insulated gate bipolar transistor, IGBT), a bidirectional switch, or the like. Certainly, the four switching transistors each may alternatively use another controllable power device. This is not limited in this implementation of this application.

In a possible implementation, the N drive pulses in the second drive signal PWM2 may exist in each cycle of the first drive signal PWM1 in the following three manners:
Manner 1: All the N drive pulses in the second drive signal PWM2 may be in low level time periods of each cycle of the first drive signal PWM1.
Manner 2: All the N drive pulses in the second drive signal PWM2 may be in high level time periods of each cycle of the first drive signal PWM1.
Manner 3: The N drive pulses in the second drive signal PWM2 may be divided into a first part of drive pulses and a second part of drive pulses. The first part of drive pulses may be in low level time periods of each cycle of the first drive signal PWM1, and the second part of drive pulses may be in high level time periods of each cycle of the first drive signal PWM1.

It should be noted that, in this implementation of this application, an example in which the two drive pulses in the second drive signal PWM2 are in low level time periods of each cycle of the first drive signal PWM1 (namely, Manner 1) is used for description.

In addition, in this implementation of this application, a quantity of drive pulses that are in the second drive signal PWM2 and that exist in low level time periods of each cycle of the first drive signal PWM1 may be not specifically limited, that is, N may be two or more, for example, three or four.

In another possible implementation, the N drive pulses in the fourth drive signal PWM4 may exist in each cycle of the third drive signal PWM3 in the following three manners:
Manner 1: All the N drive pulses in the fourth drive signal PWM4 may be in low level time periods of each cycle of the third drive signal PWM3.
Manner 2: All the N drive pulses in the fourth drive signal PWM4 may be in high level time periods of each cycle of the third drive signal PWM3.
Manner 3: The N drive pulses in the fourth drive signal may be divided into a first part of drive pulses and a second part of drive pulses. The first part of drive pulses may be in low level time periods of each cycle of the third drive signal PWM3, and the second part of drive pulses may be in high level time periods of each cycle of the third drive signal PWM3.

It should be noted that, in this implementation of this application, an example in which one drive pulse (namely, the first part of drive pulses in the two drive pulses) in the fourth drive signal PWM4 is in a high level time period of each cycle of the third drive signal PWM3 and one drive pulse (namely, the second part of drive pulses in the two drive pulses) is in a low level time period of each cycle of the third drive signal PWM3 (namely, Manner 3) is used for description.

In this implementation of this application, a quantity of drive pulses that are in the fourth drive signal PWM4 and that exist in low level time periods or high level time periods of each cycle of the third drive signal PWM3 may be not specifically limited.

Because the first drive signal PWM1 is simple, the following describes the second drive signal PWM2 in one cycle T_{sw} of the first drive signal PWM1 and the fourth drive signal PWM4 in one cycle T_{sw} of the third drive signal PWM3.

The second drive signal PWM2 in one cycle T_{sw} of the first drive signal PWM1 is first described in the following three aspects:
According to a first aspect, frequencies corresponding to at least two of the N drive pulses in the second drive signal PWM2 are different.

The following uses an example in which the second drive signal PWM2 has three drive pulses in low level time periods of each cycle T_{sw} of the first drive signal PWM1 for description, that is, frequencies corresponding to two of the three drive pulses are different.

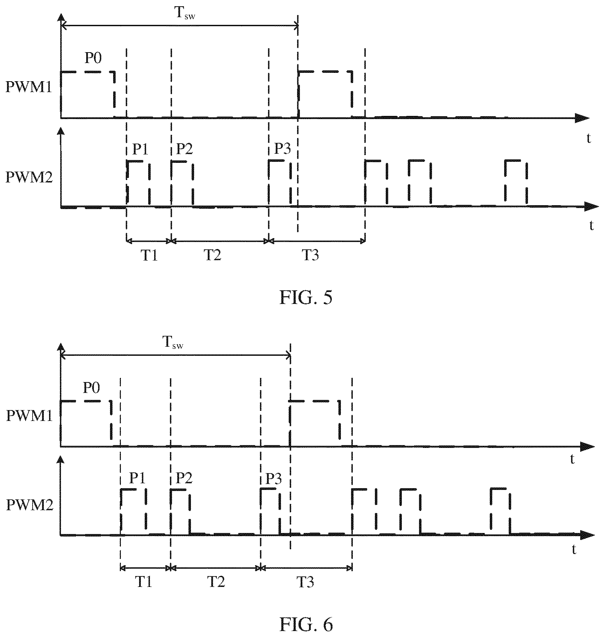

As shown in FIG. 5, P(pulse)1 represents a first drive pulse of the three drive pulses that are in the second drive signal PWM2 and that are in the low level time periods of each cycle T_{sw} of the first drive signal PWM1, P2 represents a second drive pulse, and P3 represents a third drive pulse. T1 is a cycle corresponding to the drive pulse P1, T2 is a cycle corresponding to the drive pulse P2, and T3 is a cycle corresponding to the drive pulse P3.

It can be seen from FIG. 5 that the cycle T2 corresponding to the drive pulse P2 and the cycle T3 corresponding to the drive pulse P3 are the same (that is, T2=T3). It can be learned from an inverse relationship between a cycle and a frequency that a frequency (which may be represented by f2) corresponding to the drive pulse P2 is equal to a frequency (which may be represented by f3) corresponding to the drive pulse P3, that is, f2=f3. However, both the cycle T2 corresponding to the drive pulse P2 and the cycle T3 corresponding to the drive pulse P3 are different from the cycle T1 corresponding to the drive pulse P1. Therefore, both the frequency of the drive pulse P2 and the frequency of the drive pulse P3 are different from a frequency of the drive pulse P1. It can be seen from FIG. 5 that T3>T1. Therefore, the frequency corresponding to the drive pulse P3 is less than the frequency (which may be represented by f1) corresponding to the drive pulse P1, that is, f3<f1.

P0 represents a drive pulse of the first drive signal PWM1 in one cycle T_{sw}, the drive pulse P0 corresponds to an on time of the first switching transistor S1, and the on time of the first switching transistor S1 may be obtained by multiplying a duty cycle D1 of the first switching transistor S1 by the cycle T_{sw} of the first drive signal PWM1.

Refer to FIG. 5. All pulse widths of the drive pulse P1, the drive pulse P2, and the drive pulse P3 are the same, that is, P1=P2=P3.

Certainly, the three drive pulses that are in the second drive signal PWM2 and that exist in the low level time periods of each cycle T_{sw} of the first drive signal PWM1 may be different.

For example, as shown in FIG. 6, pulse widths of a drive pulse P2 and a drive pulse P3 are the same, and the pulse widths of the drive pulse P2 and the drive pulse P3 are different from a pulse width of a drive pulse P1. It can be seen from FIG. 6 that the pulse width of the drive pulse P1 is greater than the pulse width of the drive pulse P2 (or the drive pulse P3).

Because there may be a plurality of drive pulses (for example, three drive pulses) that are in the second drive signal PWM2 and that are in low level time periods of the first drive signal PWM1, the charging and discharging frequency of the inductor L is increased. Even if the pulse widths of the drive pulses in the second drive signal PWM2 are different (as shown in FIG. 6), the inductance of the inductor L can still be reduced while a same ripple current percentage of the inductor L is ensured, thereby further reducing the size and the costs of the inductor L.

According to a second aspect, a frequency corresponding to each of the N drive pulses in the second drive signal PWM2 is different.

The following describes an implementation form of the second drive signal PWM2 by using an example in which the second drive signal PWM2 has three drive pulses in low level time periods of each cycle of the first drive signal PWM1. That is, when N=3, frequencies corresponding to the three drive pulses are different.

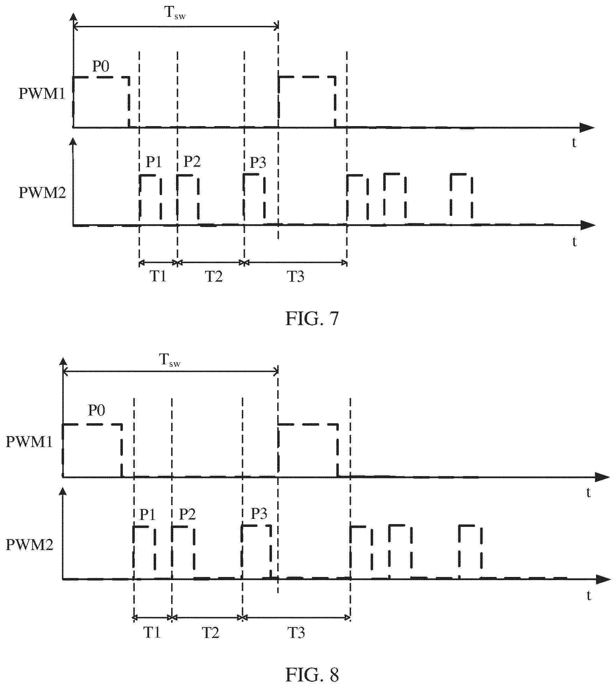

As shown in FIG. 7, a cycle T3 corresponding to a drive pulse P3 is greater than a cycle T2 corresponding to a drive pulse P2, and the cycle T2 corresponding to the drive pulse P2 is greater than a cycle T1 corresponding to a drive pulse P1, that is, T3>T2>T1. Similarly, it can be learned from an inverse relationship between a cycle and a frequency that a frequency f3 corresponding to the drive pulse P3 is less than a frequency f2 corresponding to the drive pulse P2 (that is, f3<f2), and the frequency f2 corresponding to the drive pulse P2 is less than a frequency f1 corresponding to the drive pulse P1 (that is, f2<f1). That is, all the frequencies corresponding to the drive pulse P1, the drive pulse P2, and the drive pulse P3 are different.

Certainly, pulse widths of the three drive pulses that are in the second drive signal PWM2 and that exist in the low level time periods of each cycle of the first drive signal PWM1 may alternatively be different.

As shown in FIG. 8, a cycle T3 corresponding to a drive pulse P3 is greater than a cycle T2 corresponding to a drive pulse P2, and the cycle T2 corresponding to the drive pulse P2 is greater than a cycle T1 corresponding to a drive pulse P1, that is, T3>T2>T1. In addition, a pulse width of the drive pulse P1 is equal to a pulse width of the drive pulse P2. However, both the pulse width of the drive pulse P1 and the pulse width of the drive pulse P2 are less than a pulse width of the drive pulse P3.

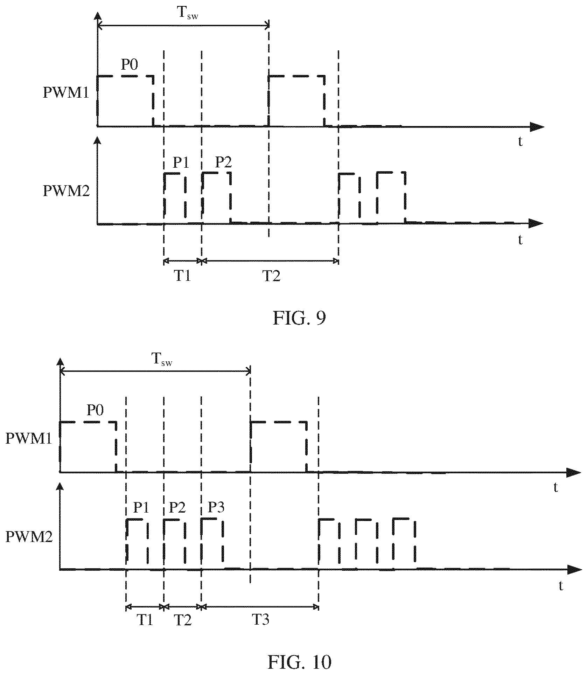

Similarly, as shown in FIG. 9, the second drive signal PWM2 may have a drive pulse P1 and a drive pulse P2 in low level time periods of each cycle of the first drive signal PWM1, where a cycle T2 corresponding to the drive pulse P2 is greater than a cycle T1 corresponding to the drive pulse P1, that is, T2>T1. In addition, a pulse width of the drive pulse P2 is greater than a pulse width of the drive pulse P1 (that is, the pulse widths of the drive pulse P1 and the drive pulse P2 are different).

It should be noted that the second drive signal PWM2 may have two drive pulses in low level time periods of each cycle of the first drive signal PWM1, and pulse widths of the two drive pulses are the same, as shown in FIG. 2. Details are not described in this implementation of this application again.

According to a third aspect, frequencies of first N-1 drive pulses of the N drive pulses in the second drive signal PWM2 are the same, and a frequency of a last drive pulse of the N drive pulses in the second drive signal is less than the frequencies of the first N-1 drive pulses.

The following uses an example in which the second drive signal PWM2 has three drive pulses in low level time periods of each cycle of the first drive signal PWM1 for description.

In an example, as shown in FIG. 10, pulse widths of a drive pulse P1, a drive pulse P2, and a drive pulse P3 are the same, and cycles of the drive pulse P1 and the drive pulse P2 (namely, first two drive pulses) are the same (that is, T1=T2). Therefore, frequencies of the drive pulse P1 and the drive pulse P2 are the same (that is, f1=f2). In addition, a cycle of the drive pulse P3 (namely, a last drive pulse of the three drive pulses) is greater than the cycles of the drive pulse P1 and the drive pulse P2, that is, a frequency of the drive pulse P3 is less than the frequency of the drive pulse P1 (or the drive pulse P2) (that is, f3<f1).

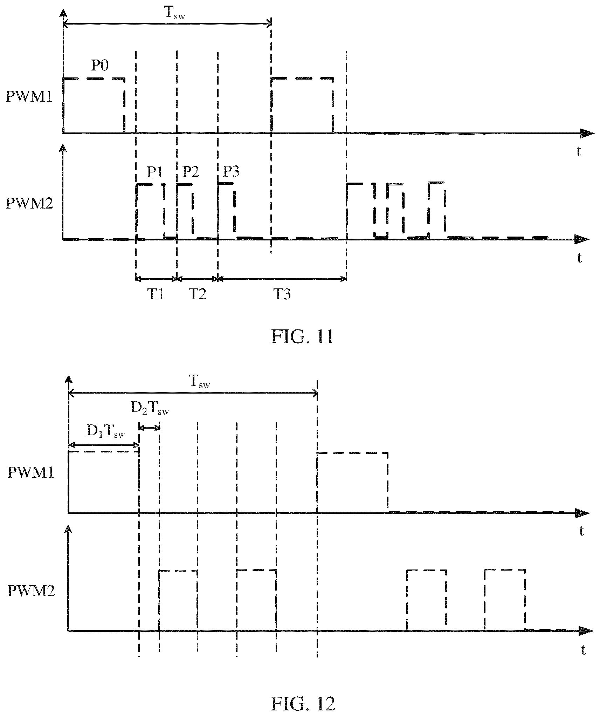

In another example, as shown in FIG. 11, a pulse width of a drive pulse P1 is greater than a pulse width of a drive pulse P2, and the pulse width of the drive pulse P2 is the same as a pulse width of a drive pulse P3. In addition, cycles of the drive pulse P1 and the drive pulse P2 are the same, that is, T1=T2, that is, frequencies of the drive pulse P1 and the drive pulse P2 are the same (that is, f1=f2). In addition, a cycle of the drive pulse P3 is greater than the cycles of the drive pulse P1 and the drive pulse P2, that is, a frequency of the drive pulse P3 is less than the frequency of the drive pulse P1 (or the drive pulse P2) (that is, f3<f1).

It can be learned from the foregoing three aspects that, in this implementation of this application, the controller sends the asymmetric drive signals to the first switching transistor S1 and the second switching transistor S2, so that the charging and discharging frequency of the inductor L increases, and the inductance of the inductor L can still be reduced while a same ripple current percentage of the inductor L is ensured, thereby further reducing the size and the costs of the inductor L.

The following describes the fourth drive signal PWM4 in one cycle T_{sw} of the third drive signal PWM3 in the following cases:
According to a first aspect, frequencies corresponding to at least two of the N drive pulses in the fourth drive signal PWM4 are different.

The following uses an example in which the fourth drive signal PWM4 has three drive pulses in each cycle T_{sw} of the third drive signal PWM3 and pulse widths of the three drive pulses are the same for description.

One drive pulse P1 exists in a low level time period of each cycle T_{sw} of the third drive signal PWM3, two drive pulses (namely, a drive pulse P2 and a drive pulse P3) exist in high level time periods of each cycle T_{sw} of the third drive signal PWM3, and all of a pulse width of the drive pulse P1, a pulse width of the drive pulse P2, and a pulse width of the drive pulse P3 are the same. If a cycle T1 corresponding to the drive pulse P1 is the same as a cycle T2 corresponding to the drive pulse P2 (that is, T1=T2), but the cycle T2 corresponding to the drive pulse P2 is different from a cycle T3 corresponding to the drive pulse P3 (that is, T2≠T3), a frequency f1 corresponding to the drive pulse P1 is the same as a frequency f2 corresponding to the drive pulse P2 (that is, f1=f2), and the frequency f2 corresponding to the drive pulse P2 is different from a frequency f3 corresponding to the drive pulse P3 (that is, f2≠f3).

Certainly, the pulse widths of the three drive pulses that are in the fourth drive signal PWM4 and that exist in each cycle T_{sw} of the third drive signal PWM3 may alternatively be different. For details, refer to the foregoing related descriptions. Details are not described in this implementation of this application again.

Because there may be a plurality of drive pulses (for example, two drive pulses) that are in the fourth drive signal PWM4 and that are in a low level time period and a high level time period of the third drive signal PWM3, the charging and discharging frequency of the inductor L is also increased. Even if the pulse widths of the drive pulses in the fourth drive signal PWM4 are different, the inductance of the inductor L can still be reduced while a same ripple current percentage of the inductor L is ensured, thereby further reducing the size and the costs of the inductor L.

According to a second aspect, a frequency corresponding to each of the N drive pulses in the fourth drive signal PWM4 is different.

The following uses an example in which the fourth drive signal PWM4 has three drive pulses in each cycle T_{sw} of the third drive signal PWM3, pulse widths of the three drive pulses are the same, and all frequencies corresponding to the three drive pulses are different for description.

One drive pulse P1 exists in a low level time period of each cycle T_{sw} of the third drive signal PWM3, a drive pulse P2 and a drive pulse P3 exist in high level time periods of each cycle T_{sw} of the third drive signal PWM3, and all of a pulse width of the drive pulse P1, a pulse width of the drive pulse P2, and a pulse width of the drive pulse P3 are the same. If all of a cycle T1 corresponding to the drive pulse P1, a cycle T2 corresponding to the drive pulse P2, and a cycle T3 corresponding to the drive pulse P3 are different (that is, T1≠T2≠T3), all of a frequency f1 corresponding to the drive pulse P1, a frequency f2 corresponding to the drive pulse P2, and a frequency f3 corresponding to the drive pulse P3 are different (that is, f1≠f2≠f3).

Certainly, the pulse widths of the three drive pulses that are in the fourth drive signal PWM4 and that exist in each cycle T_{sw} of the third drive signal PWM3 may alternatively be different. For details, refer to the foregoing related descriptions. Details are not described in this implementation of this application again.

According to a third aspect, frequencies of first N-1 drive pulses of the N drive pulses in the fourth drive signal PWM4 are the same, and a frequency of a last drive pulse of the N drive pulses in the fourth drive signal PWM4 is less than the frequencies of the first N-1 drive pulses.

Similarly, the following uses an example in which the fourth drive signal PWM4 has three drive pulses in low level time periods of each cycle of the third drive signal PWM3 for description.

In an example, pulse widths of a drive pulse P1, a drive pulse P2, and a drive pulse P3 are the same, and cycles of the drive pulse P1 and the drive pulse P2 (namely, first two drive pulses) are the same (that is, T1=T2). Therefore, frequencies of the drive pulse P1 and the drive pulse P2 are the same (that is, f1=f2). In addition, a cycle of the drive pulse P3 (namely, a last drive pulse of the three drive pulses) is greater than the cycles of the drive pulse P1 and the drive pulse P2, that is, a frequency of the drive pulse P3 is less than the frequency of the drive pulse P1 (or the drive pulse P2) (that is, f3<f1).

In another example, a pulse width of a drive pulse P1 may be greater than a pulse width of a drive pulse P2, and the pulse width of the drive pulse P2 may be the same as a pulse width of a drive pulse P3. In addition, cycles of the drive pulse P1 and the drive pulse P2 are the same, that is, T1=T2, that is, frequencies of the drive pulse P1 and the drive pulse P2 are the same (that is, f1=f2). In addition, a cycle of the drive pulse P3 is greater than the cycles of the drive pulse P1 and the drive pulse P2, that is, a frequency of the drive pulse P3 is less than the frequency of the drive pulse P1 (or the drive pulse P2) (that is, f3<f1).

It can be learned from the foregoing three aspects that, in this implementation of this application, the controller sends the asymmetric drive signals to the third switching transistor S3 and the fourth switching transistor S4, so that the charging and discharging frequency of the inductor L increases, and the inductance of the inductor L can still be reduced while a same ripple current percentage of the inductor L is ensured, thereby further reducing the size and the costs of the inductor L.

In a possible implementation, in this implementation of this application, (in each cycle of the first drive signal PWM1) a time between a rising edge of the first drive signal PWM1 and the rising edge of the first drive pulse of the N drive pulses in the second drive signal PWM2 may be defined as a lag time (which is the lag time defined in Manner 1, and is represented by T_{d1} for ease of understanding and distinguishing). Alternatively, (in each cycle of the third drive signal PWM3) a time between the rising edge of the third drive signal PWM3 and the rising edge of the first drive pulse of the N drive pulses in the fourth drive signal PWM4 may be defined as a lag time (which is the lag time defined in Manner 2, and is represented by T_{d2} for ease of understanding and distinguishing).

The following describes in detail, with reference to the accompanying drawings, manners of obtaining the lag times defined in the foregoing two manners.

For the lag time T_{d1} defined in Manner 1, for ease of understanding, in this implementation of this application, an example in which the second drive signal PWM2 has two drive pulses in each cycle of the first drive signal PWM1 and pulse widths of the two drive pulses are the same is used for description.

In a first example, because the ripple current of the inductor L is affected by the lag time T_{d1}, the controller may obtain the lag time T_{d1} based on the ripple current of the inductor L. To reduce the ripple current of the inductor L, in each charging and discharging cycle of the inductor L, the controller may control a charging current of the inductor L to be equal to a discharging current of the inductor L to obtain the lag time T_{d1}.

It can be seen from FIG. 12 that the time between the rising edge of the first drive signal PWM1 and the rising edge of the first drive pulse of the two drive pulses in the second drive signal PWM2 is D₁T_{sw}+D₂T_{sw}, that is, T_{d1}=D₁T_{sw}+D₂T_{sw}.

T_{sw} represents one cycle of the first drive signal PWM1. D₁ represents the duty cycle of the first switching transistor S1 and meets D₁+D₃=1, and D₃ represents a duty cycle of the second switching transistor S3. D₁T_{sw} represents the on time of the first switching transistor S1.

Similarly, D₂ represents a duty cycle of the second switching transistor S2 and meets D₂+D₄=1, and D₄ represents a duty cycle of the fourth switching transistor S4. D₂T_{sw} may represent a delay time between the rising edge of the first drive pulse of the two drive pulses in the second drive signal PWM2 and the falling edge of the first drive signal PWM1.

The following describes, with reference to FIG. 1 and FIG. 2, a detailed process in which the controller obtains the lag time T_{d1}.

The controller may obtain the lag time T_{d1} based on the first voltage V₁ and the second voltage V₂ of the bidirectional direct current converter shown in FIG. 1, the voltage V_{c} of the capacitor C, and the cycle T_{sw} of the first drive signal PWM1 or the third drive signal PWM3.

Optionally, the first voltage V₁ may be used to indicate the output voltage of the bidirectional direct current converter, and the second voltage V₂ may be used to indicate the input voltage of the bidirectional direct current converter. Alternatively, the first voltage V₁ may be used to indicate the input voltage of the bidirectional direct current converter, and the second voltage V₂ may be used to indicate the output voltage of the bidirectional direct current converter. In this implementation of this application, an example in which the first voltage V₁ is the input voltage and the second voltage V₂ is the output voltage is used for description.

Refer to FIG. 2. For example, the controller sends the first drive signal PWM1 to the first switching transistor S1 and sends the second drive signal PWM2 to the second switching transistor S2. In this case, the time period F11 and the time period F12 correspond to one charging and discharging cycle of the inductor L. Then the time period F11 corresponds to that the first switching transistor S1 is turned on and the second switching transistor S2 is turned off, and the time period F12 corresponds to that both the first switching transistor S1 and the second switching transistor S2 are turned off. The inductor L meets the following equation in this charging and discharging cycle: $\left({V}_{1}+{V}_{c}-{V}_{2}\right) {D}_{1} {T}_{sw} = \left({V}_{2}-{V}_{1}\right) {D}_{2} {T}_{sw}$ Formula (1)

In Formula (1), the duty cycle D₁ of the first drive signal PWM1 may meet: ${D}_{1} = 1 - {V}_{1} / {V}_{2}$ Formula (2)

Further, the controller may obtain the lag time T_{d1} based on Formula (1) and Formula (2), thereby reducing the inductance of the inductor L.

In a second example, the controller may obtain the lag time T_{d1} based on the loss of at least one of the first switching transistor S1 and the second switching transistor S2 (namely, the loss of the first switching transistor S1 and/or the loss of the second switching transistor S1).

That is, to obtain the lag time T_{d1}, the controller may obtain the lag time T_{d1} based on only the loss of the first switching transistor S1, may obtain the lag time T_{d1} based on only the loss of the second switching transistor S2, or may obtain the lag time T_{d1} based on both the loss of the first switching transistor S1 and the loss of the second switching transistor S2.

For example, the controller obtains the lag time T_{d1} based on only the loss of the first switching transistor S1. In this case, a time corresponding to a minimum loss of the first switching transistor S1 may be the lag time T_{d1}.

For another example, the controller obtains the lag time T_{d1} based on only the loss of the second switching transistor S2. In this case, a time corresponding to a minimum loss of the second switching transistor S2 may be the lag time T_{d1}.

For another example, the controller obtains the lag time T_{d1} based on both the loss of the first switching transistor S1 and the loss of the second switching transistor S2. In this case, a time corresponding to evenly distributed losses of the first switching transistor S1 and the second switching transistor S2 may be the lag time T_{d1}.

Therefore, the controller may obtain the lag time T_{d1} based on the loss of the first switching transistor S1 and/or the loss of the second switching transistor S1, thereby reducing a loss generated by the bidirectional direct current converter and improving conversion efficiency of the bidirectional direct current converter.

In a third example, the controller may obtain the lag time T_{d1} based on the ripple current of the inductor L and the loss of at least one of the first switching transistor S1 and the second switching transistor S2.

To reduce both the ripple current of the inductor L and the loss generated by the bidirectional direct current converter, the controller may obtain the lag time T_{d1} by combining the first example and the second example.

Therefore, the controller can use a time corresponding to a low ripple current of the inductor L and a low loss of at least one of the first switching transistor S1 and the second switching transistor S2 as the lag time T_{d1}.

For the lag time T_{d2} defined in Manner 2, for ease of understanding, in this implementation of this application, an example in which the fourth drive signal PWM4 has two drive pulses in each cycle of the third drive signal PWM3 and pulse widths of the two drive pulses are different is used for description.

In a first example, because the ripple current of the inductor L is affected by the lag time T_{d2}, the controller may obtain the lag time T_{d2} based on the ripple current of the inductor L. To reduce the ripple current of the inductor L, in each charging and discharging cycle of the inductor L, the controller may control a charging current of the inductor L to be equal to a discharging current of the inductor L to obtain the lag time T_{d2}.

The following describes, with reference to FIG. 1, a detailed process in which the controller obtains the lag time T_{d2}.

In a first example, the controller may obtain the lag time T_{d2} based on the loss of at least one of the third switching transistor S3 and the fourth switching transistor S4 (namely, the loss of the third switching transistor S3 and/or the loss of the fourth switching transistor S4).

That is, to obtain the lag time T_{d2}, the controller may obtain the lag time T_{d2} based on only the loss of the third switching transistor S3, may obtain the lag time T_{d2} based on only the loss of the fourth switching transistor S4, or may obtain the lag time T_{d2} based on both the loss of the third switching transistor S3 and the loss of the fourth switching transistor S4.

For example, the controller obtains the lag time T_{d2} based on only the loss of the third switching transistor S3. In this case, a time corresponding to a minimum loss of the third switching transistor S3 may be the lag time T_{d2}.

For another example, the controller obtains the lag time T_{d2} based on only the loss of the fourth switching transistor S4. In this case, a time corresponding to a minimum loss of the fourth switching transistor S4 may be the lag time T_{d2}.

For another example, the controller obtains the lag time T_{d2} based on both the loss of the third switching transistor S3 and the loss of the fourth switching transistor S4. In this case, a time corresponding to evenly distributed losses of the third switching transistor S3 and the fourth switching transistor S4 may be the lag time T_{d2}.

Therefore, the controller may obtain the lag time T_{d2} based on the loss of the third switching transistor S3 and/or the loss of the fourth switching transistor S4, thereby reducing a loss generated by the bidirectional direct current converter and improving conversion efficiency of the bidirectional direct current converter.

In a second example, the controller may obtain the lag time T_{d2} based on the ripple current of the inductor L and the loss of at least one of the third switching transistor S3 and the fourth switching transistor S4.

To reduce both the ripple current of the inductor L and the loss generated by the bidirectional direct current converter, the controller may obtain the lag time T_{d2} by combining the first example and the second example.

Therefore, the controller can use a time corresponding to a low ripple current of the inductor L and a low loss of at least one of the third switching transistor S3 and the fourth switching transistor S4 as the lag time T_{d2}.

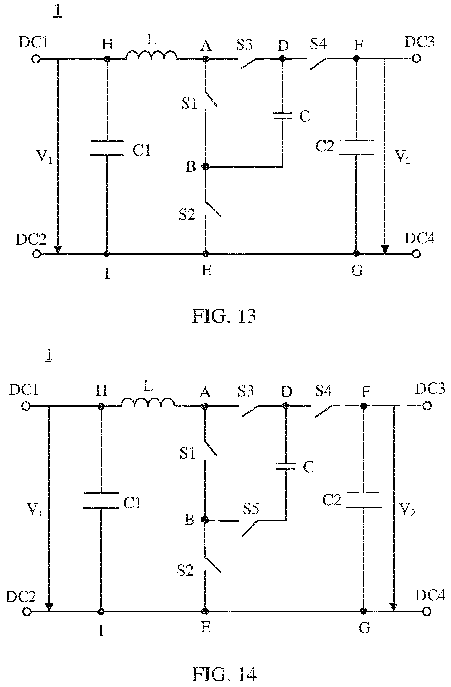

In a possible implementation, based on FIG. 1, the bidirectional direct current converter 1 provided in this implementation of this application may further include a capacitor C1 and a capacitor C2, as shown in FIG. 13.

The capacitor C1 is connected between a node H and a node I, the node H is connected to the first direct current terminal DC1, and the node I is connected to the second direct current terminal DC2. The capacitor C2 is connected between a node F and a node G, the node F is connected to the third direct current terminal DC3, and the node G is connected to the fourth direct current terminal DC4.

Optionally, one terminal (which may be a positive terminal) of the capacitor C1 is connected to the node H, and the other terminal (which may be a negative terminal) of the capacitor C1 is connected to the node I. One terminal (which may be a positive terminal) of the capacitor C2 is connected to the node F, and the other terminal (which may be a negative terminal) of the capacitor C2 is connected to the node G.

Further, based on FIG. 13, the bidirectional direct current converter 1 provided in this implementation of this application may further include a fifth switching transistor S5, as shown in FIG. 14. In FIG. 14, a first terminal (namely, a right terminal of the fifth switching transistor S5 in FIG. 14) of the fifth switching transistor S5 is connected to the second terminal of the capacitor C (namely, a lower terminal of the capacitor C in FIG. 14, which may be a negative terminal), and a second terminal (namely, a left terminal of the fifth switching transistor S5 in FIG. 14) of the fifth switching transistor S5 may be connected to the node B.

Optionally, similar to the foregoing four switching transistors such as the first switching transistor S1, the fifth switching transistor S5 may also use a MOS transistor, an IGBT, a bidirectional switch, or the like. Certainly, the fifth switching transistor S5 may alternatively be another type of controllable power device. A type of the fifth switching transistor S5 is not limited in this implementation of this application.

For example, the fifth switching transistor S5 is a MOS transistor. A drain of the fifth switching transistor S5 may be connected to the second terminal of the capacitor C, and a source of the fifth switching transistor S5 may be connected to the node B.

For another example, the fifth switching transistor S5 is an IGBT. A collector of the fifth switching transistor S5 may be connected to the second terminal of the capacitor C, and an emitter of the fifth switching transistor S5 may be connected to the node B.

The bidirectional direct current converter 1 shown in FIG. 14 may protect the second switching transistor S2 by using the fifth switching transistor S5. A principle is as follows:

In a process in which the bidirectional direct current converter 1 converts the first voltage V₁ (used as the input voltage) into the second voltage V₂ (used as the output voltage) (that is, a power is transmitted from left to right in FIG. 14), the controller may first control the fifth switching transistor S5 to be turned off. In this case, a current cannot flow through the capacitor C because the fifth switching transistor S5 is turned off. In this case, the first voltage V₁ is not applied to the second switching transistor S2. Therefore, the second switching transistor S2 is protected.

For example, when the first voltage V₁ is 900 V and the second voltage V₂ is 1200 V (the bidirectional direct current converter 1 plays a boost role), the first switching transistor S1 and the third switching transistor S3 each may use an IGBT with a low withstand voltage level, for example, 650 V. If the fifth switching transistor S5 is not disposed, the voltage V_{c} on the capacitor C is 0 at a moment when the bidirectional direct current converter 1 is connected to a power supply, that is, the first voltage V₁ is almost completely applied to the second switching transistor S2. Consequently, the voltage that needs to be borne by the second switching transistor S2 exceeds voltage stress of the second switching transistor S2, and the second switching transistor S2 is damaged.

Similarly, in a process in which the bidirectional direct current converter 1 converts the second voltage V₂ (used as the input voltage) into the first voltage V₁ (used as the output voltage) (that is, a power is transmitted from right to left in FIG. 14), the controller may first control the fifth switching transistor S5 to be turned off. In this case, a current cannot flow through the capacitor C because the fifth switching transistor S5 is turned off. In this case, the second voltage V₂ is not applied to the second switching transistor S2. Therefore, the second switching transistor S2 may be still protected.

For example, when the first voltage V₁ is 900 V and the second voltage V₂ is 1200 V (the bidirectional direct current converter 1 plays a buck role), similarly, the first switching transistor S1 and the third switching transistor S3 each may use an IGBT with a low withstand voltage level, for example, 650 V If the fifth switching transistor S5 is not disposed, the voltage V_{c} on the capacitor C is 0 at a moment when the bidirectional direct current converter 1 is connected to a power supply, that is, the second voltage V₂ is almost completely applied to the second switching transistor S2. Consequently, the voltage that needs to be borne by the second switching transistor S2 exceeds voltage stress of the second switching transistor S2, and the second switching transistor S2 is damaged.

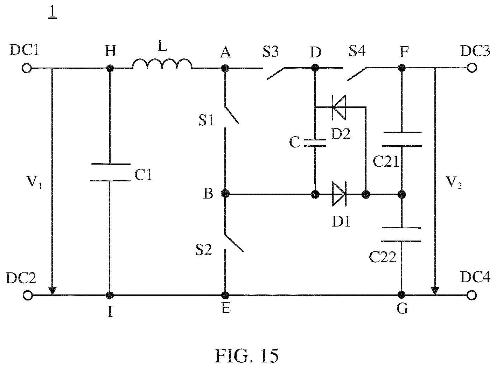

In another possible implementation, based on FIG. 13, considering pre-charging of the capacitor and an abrupt change of a voltage of a bus in the bidirectional direct current converter, the bidirectional direct current converter 1 provided in this implementation of this application may further include a first diode D1 and a second diode D2, as shown in FIG. 15.

In FIG. 15, the second capacitor C2 in FIG. 13 may be divided into a capacitor C21 and a capacitor C22, and a connection node between the capacitor C21 and the capacitor C22 is a node J (the node J may be understood as a midpoint of the second voltage V₂). An anode of the first diode D1 may be connected to a node B, and a cathode of the first diode D1 may be connected to the node J. An anode of the second diode D2 may be connected to the node J, and a cathode of the second diode D2 may be connected to the node D.

It may be understood that a function of the first diode D1 is to clamp a voltage drop borne by the second switching transistor S2, to prevent the second switching transistor S2 from bearing a voltage V_{bus} (namely, the second voltage V₂) of an entire direct current bus when the fourth switching transistor S4 is turned on. Similarly, a function of the second diode D2 is to clamp a voltage drop borne by the fourth switching transistor S4, to prevent the fourth switching transistor S4 from bearing a voltage V_{bus} (namely, the second voltage V₂) of an entire direct current bus when the second switching transistor S2 is turned on. Therefore, the first diode D1 and the second diode D2 may be referred to as clamping diodes.

A function of the bidirectional direct current converter 1 shown in FIG. 15 is the same as that of the bidirectional direct current converter 1 shown in FIG. 14. Both the functions are reducing the voltage stress borne by the second switching transistor S2 when the bidirectional direct current converter 1 is connected to the power supply and starts to work. The bidirectional direct current converter shown in FIG. 15 has the following advantages:

When the bidirectional direct current converter 1 is connected to the power supply and starts to perform forward working, the capacitor C is charged by using the first voltage V₁, and there is no moment at which the voltage of the capacitor C is zero. Therefore, the first voltage V₁ is not completely applied to the second switching transistor S2, thereby reducing the voltage stress borne by the second switching transistor S2, and protecting the second switching transistor S2.

Similarly, when the bidirectional direct current converter 1 is connected to the power supply and starts to perform reverse working, the capacitor C is charged by using the second voltage V₂, and there is no moment at which the voltage of the capacitor C is zero either. Therefore, the second voltage V₂ is not completely applied to the second switching transistor S2, thereby reducing the voltage stress borne by the second switching transistor S2, and protecting the second switching transistor.

Optionally, the first diode and the second diode each may alternatively be replaced with a switching transistor (for example, a MOS transistor, an IGBT, or a bidirectional switch). In this case, the controller only needs to send corresponding drive signals, so that the switching transistors implement working modes of the diodes. Details are not described in this implementation of this application again.

In conclusion, in the bidirectional direct current converters 1 shown in FIG. 14 and FIG. 15, the controller may also send the asymmetric drive signals to the first switching transistor S1 and the second switching transistor S2, and send the asymmetric drive signals to the third switching transistor S3 and the fourth switching transistor S4. This can also increase the charging and discharging frequency of the inductor L, reduce the ripple current of the inductor L, reduce the inductance of the inductor L, and reduce the size and the costs of the entire bidirectional direct current converter.

An implementation of this application further provides an electronic device. The electronic device may include a bidirectional direct current converter. For detailed descriptions of the bidirectional direct current converter, refer to the foregoing descriptions. Details are not described in this implementation of this application again.

The foregoing describes the bidirectional direct current converter in detail. The following describes a control method of the bidirectional direct current converter. As shown in FIG. 16, the control method 100 may include: A controller performs complementary control on a first switching transistor S1 and a third switching transistor S3, and performs complementary control on a second switching transistor S2 and a fourth switching transistor S4.

The complementary control is used to indicate that two switching transistors in complementary control cannot be simultaneously turned on or off. For example, the first switching transistor S1 and the third switching transistor S3 cannot be simultaneously turned on or off, and the second switching transistor S2 and the fourth switching transistor S4 cannot be simultaneously turned on or off.

Optionally, the controller controls a quantity of on times of the second switching transistor S2 to be greater than a quantity of on times of the first switching transistor S1 in a same cycle. It may also be understood as that, in one cycle, the controller may control a switching frequency of the second switching transistor S2 to be greater than a switching frequency of the first switching transistor S1, thereby reducing losses of the first switching transistor S1 and the second switching transistor S2.

In the control method provided in this implementation of this application, the controller controls the quantity of on times of the second switching transistor to be different from the quantity of on times of the first switching transistor in a same cycle. This can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, in any cycle of the first switching transistor S1, there may be a delay between an on moment of the first switching transistor S1 and an on moment of the second switching transistor S2. That is, the first switching transistor S1 and the second switching transistor S2 are not simultaneously turned on in any cycle.

Further, a cycle of the first switching transistor S1 may be the same as a cycle of the third switching transistor S3.

In a possible implementation, the control method may further include: The controller controls a quantity of on times of the fourth switching transistor S4 to be greater than a quantity of on times of the third switching transistor S3 in a same cycle. It may also be understood as that, in one cycle, the controller may control a switching frequency of the fourth switching transistor S4 to be greater than a switching frequency of the third switching transistor S3, thereby reducing losses of the third switching transistor S3 and the fourth switching transistor S4.

It may be understood that the controller controls the quantity of on times of the fourth switching transistor to be different from the quantity of on times of the third switching transistor in a same cycle. Similarly, this can increase a quantity of charging and discharging times of the inductor in one cycle, that is, increase a charging and discharging frequency of the inductor. Therefore, the inductor with a small inductance may be used while a same ripple current percentage of the inductor is ensured. In addition, the inductor with a small inductance has a small size and low costs. This can reduce a size and costs of the bidirectional direct current converter. When the size of the bidirectional direct current converter is reduced, power density of the bidirectional direct current converter can be increased.

In a possible implementation, the controller may send a first drive signal PWM1 to the first switching transistor S1, send a second drive signal PWM2 to the second switching transistor S2, send a third drive signal PWM3 to the third switching transistor S3, and send a fourth drive signal PWM4 to the fourth switching transistor S4, to implement complementary control on the first switching transistor S1 and the third switching transistor S3, and implement complementary control on the second switching transistor S2 and the fourth switching transistor S4.

Optionally, the cycle of the first switching transistor S1 may be the same as the cycle of the third switching transistor S3. Therefore, a cycle of the first drive signal may be the same as a cycle of the third drive signal.

The second drive signal may have N drive pulses in each cycle of the first drive signal, that is, the second drive signal and the first drive signal are two asymmetric drive signals.

Similarly, the fourth drive signal may also have N drive pulses in each cycle of the third drive signal, that is, the fourth drive signal and the third drive signal are two asymmetric drive signals.

An inductor in the bidirectional direct current converter has N+1 charging and discharging cycles in each cycle of the first drive signal or the third drive signal, where N may be an integer greater than or equal to 2. A value of N is not limited in this implementation of this application.

When the first switching transistor S1 is turned on, the inductor L may perform charging and discharging for at least two times by sending the second drive signal PWM2 to the second switching transistor S2. Certainly, when the second switching transistor S2 is turned off, the inductor L may alternatively perform charging and discharging for one time by sending the first drive signal PWM1 to the first switching transistor S1.

Similarly, when the third switching transistor S3 is turned on, the inductor L may perform charging and discharging for at least two times by sending the fourth drive signal PWM4 to the fourth switching transistor S4. When the fourth switching transistor S4 is turned on, the inductor L may alternatively perform charging and discharging for one time by sending the third drive signal PWM3 to the third switching transistor S3.

It can be learned that, in one cycle of the first drive signal PWM1 or the third drive signal PWM3, the inductor L has at least three charging and discharging cycles. The controller increases a charging and discharging frequency of the inductor L in each cycle (namely, frequency increase), thereby reducing an inductance of the inductor L, and reducing a size and costs of the inductor L.

It should be noted that, for detailed descriptions of the first drive signal, the second drive signal, the third drive signal, and the fourth drive signal, refer to the foregoing descriptions. Details are not described in this implementation of this application again.

The scope of protection is defined by the appended claims.

## Claims

1. A bidirectional direct current converter (1), comprising a first switching transistor (S1), a second switching transistor (S2), a third switching transistor (S3), a fourth switching transistor (S4), a capacitor (C), an inductor (L), and a controller, wherein
a first terminal of the inductor (L) is connected to a first direct current terminal of the bidirectional direct current converter (1), a second terminal of the inductor (L) is connected to a first node, a first electrode of the first switching transistor (S1) is connected to the first node, a second electrode of the first switching transistor (S1) is connected to a second node, a first electrode of the second switching transistor (S2) is connected to the second node, a second electrode of the second switching transistor (S2) is connected to a second direct current terminal of the bidirectional direct current converter (1) and a fourth direct current terminal of the bidirectional direct current converter (1), a first electrode of the third switching transistor (S3) is connected to the first node, a second electrode of the third switching transistor (S3) is connected to a third node, a first electrode of the fourth switching transistor (S4) is connected to the third node, a second electrode of the fourth switching transistor (S4) is connected to a third direct current terminal of the bidirectional direct current converter (1), a first terminal of the capacitor (C) is connected to the third node, a second terminal of the capacitor (C) is connected to the second node, and the controller is connected to the first switching transistor (S1), the second switching transistor (S2), the third switching transistor (S3), and the fourth switching transistor (S4); and
the controller is configured to: perform complementary control on the first switching transistor (S1) and the third switching transistor (S3), and perform complementary control on the second switching transistor (S2) and the fourth switching transistor (S4), wherein the complementary control is used to indicate that two switching transistors in complementary control cannot be simultaneously turned on or off; and the controller is further configured to control a quantity of on times of the second switching transistor (S2) to be greater than a quantity of on times of the first switching transistor (S1) in a same cycle, to reduce losses of the first switching transistor (S1) and the second switching transistor (S2);
wherein the controller is configured to:
send a first drive signal to the first switching transistor (S1), send a second drive signal to the second switching transistor (S2), send a third drive signal to the third switching transistor (S3), and send a fourth drive signal to the fourth switching transistor (S4), to implement complementary control on the first switching transistor (S1) and the third switching transistor (S3), and implement complementary control on the second switching transistor (S2) and the fourth switching transistor (S4), wherein
the second drive signal has N drive pulses in each cycle of the first drive signal, the fourth drive signal has N drive pulses in each cycle of the third drive signal, and the inductor has N+1 charging and discharging cycles in each cycle of the first or the third drive signal, wherein N is an integer and N≥3; and
wherein a frequency corresponding to each of the N drive pulses in the second drive signal or the fourth drive signal is different.

2. The bidirectional direct current converter (1) according to claim 1, wherein in any cycle of the first switching transistor (S1), there is a delay between an on moment of the first switching transistor (S1) and an on moment of the second switching transistor (S2).

3. The bidirectional direct current converter (1) according to claim 2, wherein a cycle of the first switching transistor (S1) is the same as a cycle of the third switching transistor (S3).

4. The bidirectional direct current converter (1) according to claim 2 or 3, wherein the controller is further configured to:
control a quantity of on times of the fourth switching transistor (S4) to be greater than a quantity of on times of the third switching transistor (S3) in a same cycle, to reduce losses of the third switching transistor (S3) and the fourth switching transistor (S4).

5. The bidirectional direct current converter (1) according to any of claims 1 to 4, wherein the N drive pulses in the second drive signal are in low level time periods of each cycle of the first drive signal.

6. The bidirectional direct current converter (1) according to any of claims 1 to 5, wherein a first part of pulses of the N drive pulses of the fourth drive signal are in low level time periods of each cycle of the third drive signal; and
a second part of pulses of the N pulses of the fourth drive signal are in high level time periods of each cycle of the third drive signal.

7. The bidirectional direct current converter (1) according to any of claims 1 to 6, wherein a pulse width of each of the N drive pulses in the second drive signal or the fourth drive signal is the same.

8. The bidirectional direct current converter (1) according to any one of claims 1 to 7, wherein in each cycle of the first drive signal, a rising edge of a first drive pulse of the N drive pulses in the second drive signal is behind a falling edge of the first drive signal.

9. The bidirectional direct current converter (1) according to claim 8, wherein in each cycle of the third drive signal, a rising edge of a first drive pulse of the N drive pulses in the fourth drive signal is in front of a falling edge of the third drive signal.

10. The bidirectional direct current converter (1) according to claim 9, wherein in each cycle of the first drive signal, a time between a rising edge of the first drive signal and the rising edge of the first drive pulse of the N drive pulses in the second drive signal is a lag time; or
in each cycle of the third drive signal, a time between a rising edge of the third drive signal and the rising edge of the first drive pulse of the N drive pulses in the fourth drive signal is a lag time.

11. The bidirectional direct current converter (1) according to claim 10, wherein the controller is further configured to:
in each charging and discharging cycle of the inductor (L), control a charging current of the inductor (L) to be equal to a discharging current of the inductor (L) to obtain the lag time.

12. The bidirectional direct current converter (1) according to claim 11, wherein the controller is specifically configured to:
obtain the lag time based on a first voltage of the bidirectional direct current converter (1), a second voltage of the bidirectional direct current converter (1), a voltage of the capacitor (C), and the cycle of the first drive signal/the third drive signal, wherein
the first voltage is used to indicate an input voltage of the bidirectional direct current converter (1), and the second voltage is used to indicate an output voltage of the bidirectional direct current converter (1); or
the first voltage is used to indicate an output voltage of the bidirectional direct current converter (1), and the second voltage is used to indicate an input voltage of the bidirectional direct current converter (1).

13. The bidirectional direct current converter (1) according to claim 12, wherein the controller is specifically configured to:
obtain the lag time according to the following formula: (V₁ + V_{c} - V₂)D₁T_{sw} = (V₂ - V₁)D₂T_{sw}, wherein the lag time is (D₁+D₂)T_{sw}; and
in the formula, V₁ represents the first voltage of the bidirectional direct current converter (1), V₂ represents the second voltage of the bidirectional direct current converter (1), V_{c} represents the voltage of the capacitor (C), T_{sw} represents the cycle of the first drive signal or the third drive signal, D₁ represents a duty cycle of the first drive signal, and D₂T_{sw} represents a delay time between the rising edge of the first drive pulse of the N drive pulses in the second drive signal and the falling edge of the first drive signal.

14. The bidirectional direct current converter (1) according to claim 10, wherein the controller is further configured to:
obtain the lag time based on the loss of the first switching transistor (S1) and/or the loss of the second switching transistor (S2), or
obtain the lag time based on the loss of the third switching transistor (S3) and/or the loss of the fourth switching transistor (S4),
or the controller is further configured to:
obtain the lag time based on a ripple current of the inductor (L) and the loss of at least one of the first switching transistor (S1) and the second switching transistor (S2); or
obtain the lag time based on a ripple current of the inductor (L) and the loss of at least one of the third switching transistor (S3) and the fourth switching transistor (S4),
wherein each cycle of the first drive signal is the same as each cycle of the third drive signal,
wherein the bidirectional direct current converter (1) further comprises a fifth switching transistor; and
a first terminal of the fifth switching transistor is connected to the second terminal of the capacitor (C), and a second terminal of the fifth switching transistor is connected to the second node.

15. A control method of a bidirectional direct current converter (1), wherein the bidirectional direct current converter (1) comprises a first switching transistor (S1), a second switching transistor (S2), a third switching transistor (S3), a fourth switching transistor (S4), a capacitor (C), an inductor (L), and a controller, wherein
a first terminal of the inductor (L) is connected to a first direct current terminal of the bidirectional direct current converter (1), a second terminal of the inductor (L) is connected to a first node, a first electrode of the first switching transistor (S1) is connected to the first node, a second electrode of the first switching transistor (S1) is connected to a second node, a first electrode of the second switching transistor (S2) is connected to the second node, a second electrode of the second switching transistor (S2) is connected to a second direct current terminal of the bidirectional direct current converter (1) and a fourth direct current terminal of the bidirectional direct current converter (1), a first electrode of the third switching transistor (S3) is connected to the first node, a second electrode of the third switching transistor (S3) is connected to a third node, a first electrode of the fourth switching transistor (S4) is connected to the third node, a second electrode of the fourth switching transistor (S4) is connected to a third direct current terminal of the bidirectional direct current converter (1), a first terminal of the capacitor (C) is connected to the third node, a second terminal of the capacitor (C) is connected to the second node, and the controller is connected to the first switching transistor (S1), the second switching transistor (S2), the third switching transistor (S3), and the fourth switching transistor (S4); and
the control method comprises:
performing, by the controller, complementary control on the first switching transistor (S1) and the third switching transistor (S3), and performing complementary control on the second switching transistor (S2) and the fourth switching transistor (S4), wherein the complementary control is used to indicate that two switching transistors in complementary control cannot be simultaneously turned on or off;
wherein the method specifically comprises:
controlling a quantity of on times of the second switching transistor (S2) to be greater than a quantity of on times of the first switching transistor (S1) in a same cycle, to reduce losses of the first switching transistor (S1) and the second switching transistor (S2);
wherein the controller is configured to:
send a first drive signal to the first switching transistor (S1), send a second drive signal to the second switching transistor (S2), send a third drive signal to the third switching transistor (S3), and send a fourth drive signal to the fourth switching transistor (S4), to implement complementary control on the first switching transistor (S1) and the third switching transistor (S3), and implement complementary control on the second switching transistor (S2) and the fourth switching transistor (S4), wherein
the second drive signal has N drive pulses in each cycle of the first drive signal, the fourth drive signal has N drive pulses in each cycle of the third drive signal, and the inductor has N+1 charging and discharging cycles in each cycle of the first or the third drive signal, wherein N≥3; and
wherein a frequency corresponding to each of the N drive pulses in the second drive signal or the fourth drive signal is different.

## Patentansprüche

1. Bidirektionaler Gleichstromwandler (1), umfassend einen ersten Schalttransistor (S1), einen zweiten Schalttransistor (S2), einen dritten Schalttransistor (S3), einen vierten Schalttransistor (S4), einen Kondensator (C), einen Induktor (L) und eine Steuerung, wobei
ein erster Anschluss des Induktors (L) mit einem ersten Gleichstromanschluss des bidirektionalen Gleichstromwandlers (1) verbunden ist, ein zweiter Anschluss des Induktors (L) mit einem ersten Knoten verbunden ist, eine erste Elektrode des ersten Schalttransistors (S1) mit dem ersten Knoten verbunden ist, eine zweite Elektrode des ersten Schalttransistors (S1) mit einem zweiten Knoten verbunden ist, eine erste Elektrode des zweiten Schalttransistors (S2) mit dem zweiten Knoten verbunden ist, eine zweite Elektrode des zweiten Schalttransistors (S2) mit einem zweiten Gleichstromanschluss des bidirektionalen Gleichstromwandlers (1) und einem vierten Gleichstromanschluss des bidirektionalen Gleichstromwandlers (1) verbunden ist, eine erste Elektrode des dritten Schalttransistors (S3) mit dem ersten Knoten verbunden ist, eine zweite Elektrode des dritten Schalttransistors (S3) mit einem dritten Knoten verbunden ist, eine erste Elektrode des vierten Schalttransistors (S4) mit dem dritten Knoten verbunden ist, eine zweite Elektrode des vierten Schalttransistors (S4) mit einem dritten Gleichstromanschluss des bidirektionalen Gleichstromwandlers (1) verbunden ist, ein erster Anschluss des Kondensators (C) mit dem dritten Knoten verbunden ist, ein zweiter Anschluss des Kondensators (C) mit dem zweiten Knoten verbunden ist und die Steuerung mit dem ersten Schalttransistor (S1), dem zweiten Schalttransistor (S2), dem dritten Schalttransistor (S3) und dem vierten Schalttransistor (S4) verbunden ist; und
wobei die Steuerung zu Folgendem konfiguriert ist: Durchführen einer komplementäre Kontrolle des ersten Schalttransistors (S1) und des dritten Schalttransistors (S3) und Durchführen einer komplementären Kontrolle des zweiten Schalttransistors (S2) und des vierten Schalttransistors (S4), wobei die komplementäre Kontrolle dazu verwendet wird, anzugeben, dass zwei Schalttransistoren in komplementärer Kontrolle nicht gleichzeitig ein- oder ausgeschaltet werden können; und die Steuerung ferner dazu konfiguriert ist, eine Anzahl von Einschaltzeiten des zweiten Schalttransistors (S2) so zu steuern, dass sie größer als eine Anzahl von Einschaltzeiten des ersten Schalttransistors (S1) in einem gleichen Zyklus ist, um Verluste des ersten Schalttransistors (S1) und des zweiten Schalttransistors (S2) zu reduzieren;
wobei die Steuerung zu Folgendem konfiguriert ist:
Senden eines ersten Ansteuersignals an den ersten Schalttransistor (S1), Senden eines zweiten Ansteuersignals an den zweiten Schalttransistor (S2), Senden eines dritten Ansteuersignals an den dritten Schalttransistor (S3) und Senden eines vierten Ansteuersignals an den vierten Schalttransistor (S4), um eine komplementäre Kontrolle des ersten Schalttransistors (S1) und des dritten Schalttransistors (S3) zu implementieren und eine komplementäre Kontrolle des zweiten Schalttransistors (S2) und des vierten Schalttransistors (S4) zu implementieren, wobei
das zweite Ansteuersignal N Ansteuerimpulse in jedem Zyklus des ersten Ansteuersignals aufweist, das vierte Ansteuersignal N Ansteuerimpulse in jedem Zyklus des dritten Ansteuersignals aufweist und der Induktor N+1 Lade- und Entladezyklen in jedem Zyklus des ersten oder des dritten Ansteuersignals durchläuft, wobei N eine ganze Zahl ist und N≥3 gilt; und
wobei eine Frequenz, die jedem der N Ansteuerimpulse in dem zweiten Ansteuersignal oder dem vierten Ansteuersignal entspricht, unterschiedlich ist.

2. Bidirektionaler Gleichstromwandler (1) nach Anspruch 1, wobei in jedem Zyklus des ersten Schalttransistors (S1) eine Verzögerung zwischen einem Einschaltzeitpunkt des ersten Schalttransistors (S1) und einem Einschaltzeitpunkt des zweiten Schalttransistors (S2) vorliegt.

3. Bidirektionaler Gleichstromwandler (1) nach Anspruch 2, wobei ein Zyklus des ersten Schalttransistors (S1) mit einem Zyklus des dritten Schalttransistors (S3) übereinstimmt.

4. Bidirektionaler Gleichstromwandler (1) nach Anspruch 2 oder 3, wobei die Steuerung ferner zu Folgendem konfiguriert ist:
Steuern einer Anzahl von Einschaltzeiten des vierten Schalttransistors (S4), sodass sie größer als eine Anzahl von Einschaltzeiten des dritten Schalttransistors (S3) in einem gleichen Zyklus ist, um Verluste des dritten Schalttransistors (S3) und des vierten Schalttransistors (S4) zu reduzieren.

5. Bidirektionaler Gleichstromwandler (1) nach einem der Ansprüche 1 bis 4, wobei die N Ansteuerimpulse in dem zweiten Ansteuersignal in Niedrigpegel-Zeiträumen jedes Zyklus des ersten Ansteuersignals liegen.

6. Bidirektionale Gleichstromwandler (1) nach einem der Ansprüche 1 bis 5, wobei ein erster Teil von Impulsen der N Ansteuerimpulse des vierten Ansteuersignals in Niedrigpegel-Zeiträumen jedes Zyklus des dritten Ansteuersignals liegt; und ein zweiter Teil von Impulsen der N Impulse des vierten Ansteuersignals in Hochpegel-Zeiträumen jedes Zyklus des dritten Ansteuersignals liegt.

7. Bidirektionaler Gleichstromwandler (1) nach einem der Ansprüche 1 bis 6, wobei eine Impulsbreite jedes der N Ansteuerimpulse in dem zweiten Ansteuersignal oder in dem vierten Ansteuersignal übereinstimmt.

8. Bidirektionaler Gleichstromwandler (1) nach einem der Ansprüche 1 bis 7, wobei in jedem Zyklus des ersten Ansteuersignals eine steigende Flanke eines ersten Ansteuerimpulses der N Ansteuerimpulse in dem zweiten Ansteuersignal hinter einer fallenden Flanke des ersten Ansteuersignals liegt.

9. Bidirektionaler Gleichstromwandler (1) nach Anspruch 8, wobei in jedem Zyklus des dritten Ansteuersignals eine steigende Flanke eines ersten Ansteuerimpulses der N Ansteuerimpulse in dem vierten Ansteuersignal vor einer fallenden Flanke des dritten Ansteuersignals liegt.

10. Bidirektionaler Gleichstromwandler (1) nach Anspruch 9, wobei in jedem Zyklus des ersten Ansteuersignals eine Zeit zwischen einer steigenden Flanke des ersten Ansteuersignals und der steigenden Flanke des ersten Ansteuerimpulses der N Ansteuerimpulse in dem zweiten Ansteuersignal eine Verzögerungszeit ist; oder
in jedem Zyklus des dritten Ansteuersignals eine Zeit zwischen einer steigenden Flanke des dritten Ansteuersignals und der steigenden Flanke des ersten Ansteuerimpulses der N Ansteuerimpulse in dem vierten Ansteuersignal eine Verzögerungszeit ist.

11. Bidirektionaler Gleichstromwandler (1) nach Anspruch 10, wobei die Steuerung ferner zu Folgendem konfiguriert ist:
Steuern eines Ladestroms des Induktors (L), sodass er mit dem Entladestrom des Induktors (L) übereinstimmt, in jedem Lade- und Entladezyklus des Induktors (L), um die Verzögerungszeit zu erlangen.

12. Bidirektionaler Gleichstromwandler (1) nach Anspruch 11, wobei die Steuerung insbesondere zu Folgendem konfiguriert ist:
Erlangen der Verzögerungszeit basierend auf einer ersten Spannung des bidirektionalen Gleichstromwandlers (1), einer zweiten Spannung des bidirektionalen Gleichstromwandlers (1), einer Spannung des Kondensators (C) und dem Zyklus des ersten Ansteuersignals/des dritten Ansteuersignals, wobei
die erste Spannung dazu verwendet wird, eine Eingangsspannung des bidirektionalen Gleichstromwandlers (1) anzugeben, und die zweite Spannung dazu verwendet wird, eine Ausgangsspannung des bidirektionalen Gleichstromwandlers (1) anzugeben; oder
die erste Spannung dazu verwendet wird, eine Ausgangsspannung des bidirektionalen Gleichstromwandlers (1) anzugeben, und die zweite Spannung dazu verwendet wird, eine Eingangsspannung des bidirektionalen Gleichstromwandlers (1) anzugeben.

13. Bidirektionaler Gleichstromwandler (1) nach Anspruch 12, wobei die Steuerung insbesondere zu Folgendem konfiguriert ist:
Erlangen der Verzögerungszeit entsprechend folgender Formel: (V₁ + V_{c} - V₂)D₁T_{sw} = (V₂ - V₁)D₂T_{sw}, wobei die Verzögerungszeit (D₁ + D₂)T_{sw} beträgt; und
in der Formel V₁ für die erste Spannung des bidirektionalen Gleichstromwandlers (1) steht, V₂ für die zweite Spannung des bidirektionalen Gleichstromwandlers (1) steht, V_{c} für die Spannung des Kondensators (C) steht, T_{sw} für den Zyklus des ersten Ansteuersignals oder des dritten Ansteuersignals steht, D₁ für einen Arbeitszyklus des ersten Ansteuersignals steht und D₂T_{sw} für eine Verzögerungszeit zwischen der steigenden Flanke des ersten Ansteuerimpulses der N Ansteuerimpulse in dem zweiten Ansteuersignal und der fallenden Flanke des ersten Ansteuersignals steht.

14. Bidirektionaler Gleichstromwandler (1) nach Anspruch 10, wobei die Steuerung ferner zu Folgendem konfiguriert ist:
Erlangen der Verzögerungszeit basierend auf dem Verlust des ersten Schalttransistors (S1) und/oder dem Verlust des zweiten Schalttransistors (S2) oder
Erlangen der Verzögerungszeit basierend auf dem Verlust des dritten Schalttransistors (S3) und/oder dem Verlust des vierten Schalttransistors (S4),
oder die Steuerung ferner zu Folgendem konfiguriert ist:
Erlangen der Verzögerungszeit basierend auf einem Restwelligkeitsstrom des Induktors (L) und dem Verlust an mindestens einem von dem ersten Schalttransistor (S1) und dem zweiten Schalttransistor (S2); oder
Erlangen der Verzögerungszeit basierend auf einem Restwelligkeitsstrom des Induktors (L) und dem Verlust an mindestens einem von dem dritten Schalttransistor (S3) und dem vierten Schalttransistor (S4),
wobei jeder Zyklus des ersten Ansteuersignals mit jedem Zyklus des dritten Ansteuersignals übereinstimmt,
wobei der bidirektionale Gleichstromwandler (1) ferner einen fünften Schalttransistor umfasst; und
ein erster Anschluss des fünften Schalttransistors mit dem zweiten Anschluss des Kondensators (C) verbunden ist und ein zweiter Anschluss des fünften Schalttransistors mit dem zweiten Knoten verbunden ist.

15. Steuerungsverfahren für einen bidirektionalen Gleichstromwandler (1), wobei der bidirektionale Gleichstromwandler (1) einen ersten Schalttransistor (S1), einen zweiten Schalttransistor (S2), einen dritten Schalttransistor (S3), einen vierten Schalttransistor (S4), einen Kondensator (C), einen Induktor (L) und eine Steuerung umfasst, wobei
ein erster Anschluss des Induktors (L) mit einem ersten Gleichstromanschluss des bidirektionalen Gleichstromwandlers (1) verbunden ist, ein zweiter Anschluss des Induktors (L) mit einem ersten Knoten verbunden ist, eine erste Elektrode des ersten Schalttransistors (S1) mit dem ersten Knoten verbunden ist, eine zweite Elektrode des ersten Schalttransistors (S1) mit einem zweiten Knoten verbunden ist, eine erste Elektrode des zweiten Schalttransistors (S2) mit dem zweiten Knoten verbunden ist, eine zweite Elektrode des zweiten Schalttransistors (S2) mit einem zweiten Gleichstromanschluss des bidirektionalen Gleichstromwandlers (1) und einem vierten Gleichstromanschluss des bidirektionalen Gleichstromwandlers (1) verbunden ist, eine erste Elektrode des dritten Schalttransistors (S3) mit dem ersten Knoten verbunden ist, eine zweite Elektrode des dritten Schalttransistors (S3) mit einem dritten Knoten verbunden ist, eine erste Elektrode des vierten Schalttransistors (S4) mit dem dritten Knoten verbunden ist, eine zweite Elektrode des vierten Schalttransistors (S4) mit einem dritten Gleichstromanschluss des bidirektionalen Gleichstromwandlers (1) verbunden ist, ein erster Anschluss des Kondensators (C) mit dem dritten Knoten verbunden ist, ein zweiter Anschluss des Kondensators (C) mit dem zweiten Knoten verbunden ist und die Steuerung mit dem ersten Schalttransistor (S1), dem zweiten Schalttransistor (S2), dem dritten Schalttransistor (S3) und dem vierten Schalttransistor (S4) verbunden ist; und
das Steuerungsverfahren Folgendes umfasst:
Durchführen einer komplementärer Kontrolle des ersten Schalttransistors (S1) und des dritten Schalttransistors (S3) durch die Steuerung und Durchführen einer komplementären Kontrolle des zweiten Schalttransistors (S2) und des vierten Schalttransistors (S4), wobei die komplementäre Kontrolle dazu verwendet wird, anzugeben, dass zwei Schalttransistoren in komplementärer Kontrolle nicht gleichzeitig ein- oder ausgeschaltet werden können;
wobei das Verfahren insbesondere Folgendes umfasst:
Steuern einer Anzahl von Einschaltzeiten des zweiten Schalttransistors (S2), sodass sie größer ist als eine Anzahl der Einschaltzeiten des ersten Schalttransistors (S1) in einem gleichen Zyklus, um Verluste des ersten Schalttransistors (S1) und des zweiten Schalttransistors (S2) zu reduzieren;
wobei die Steuerung zu Folgendem konfiguriert ist:
Senden eines ersten Ansteuersignals an den ersten Schalttransistor (S1), Senden eines zweiten Ansteuersignals an den zweiten Schalttransistor (S2), Senden eines dritten Ansteuersignals an den dritten Schalttransistor (S3) und Senden eines vierten Ansteuersignals an den vierten Schalttransistor (S4), um eine komplementäre Kontrolle des ersten Schalttransistors (S1) und des dritten Schalttransistors (S3) zu implementieren und eine komplementäre Kontrolle des zweiten Schalttransistors (S2) und des vierten Schalttransistors (S4) zu implementieren, wobei
das zweite Ansteuersignal N Ansteuerimpulse in jedem Zyklus des ersten Ansteuersignals aufweist, das vierte Ansteuersignal N Ansteuerimpulse in jedem Zyklus des dritten Ansteuersignals aufweist und der Induktor N+1 Lade- und Entladezyklen in jedem Zyklus des ersten oder des dritten Ansteuersignals durchläuft, wobei N≥3 gilt; und
wobei eine Frequenz, die jedem der N Ansteuerimpulse in dem zweiten Ansteuersignal oder dem vierten Ansteuersignal entspricht, unterschiedlich ist.

## Revendications

1. Convertisseur de courant continu bidirectionnel (1), comprenant un premier transistor de commutation (S1), un deuxième transistor de commutation (S2), un troisième transistor de commutation (S3), un quatrième transistor de commutation (S4), un condensateur (C), une inductance (L) et un dispositif de commande, dans lequel
une première borne de l'inductance (L) est connectée à une première borne de courant continu du convertisseur de courant continu bidirectionnel (1), une seconde borne de l'inductance (L) est connectée à un premier nœud, une première électrode du premier transistor de commutation (S1) est connectée au premier nœud, une seconde électrode du premier transistor de commutation (S1) est connectée à un deuxième nœud, une première électrode du deuxième transistor de commutation (S2) est connectée au deuxième nœud, une seconde électrode du deuxième transistor de commutation (S2) est connectée à une deuxième borne de courant continu du convertisseur de courant continu bidirectionnel (1) et à une quatrième borne de courant continu du convertisseur de courant continu bidirectionnel (1), une première électrode du troisième transistor de commutation (S3) est connectée au premier nœud, une seconde électrode du troisième transistor de commutation (S3) est connectée à un troisième nœud, une première électrode du quatrième transistor de commutation (S4) est connectée au troisième nœud, une seconde électrode du quatrième transistor de commutation (S4) est connectée à une troisième borne de courant continu du convertisseur de courant continu bidirectionnel (1), une première borne du condensateur (C) est connectée au troisième nœud, une seconde borne du condensateur (C) est connectée au deuxième nœud, et le dispositif de commande est connecté au premier transistor de commutation (S1), au deuxième transistor de commutation (S2), au troisième transistor de commutation (S3) et au quatrième transistor de commutation (S4) ; et
le dispositif de commande est configuré pour : réaliser une commande complémentaire sur le premier transistor de commutation (S1) et le troisième transistor de commutation (S3), et réaliser une commande complémentaire sur le deuxième transistor de commutation (S2) et le quatrième transistor de commutation (S4), dans lequel la commande complémentaire est utilisée pour indiquer que deux transistors de commutation en commande complémentaire ne peuvent pas être allumés ou éteints simultanément ; et le dispositif de commande est en outre configuré pour commander une quantité de temps d'activation du deuxième transistor de commutation (S2) pour qu'elle soit supérieure à une quantité de temps d'activation du premier transistor de commutation (S1) dans un même cycle, afin de réduire les pertes du premier transistor de commutation (S1) et du deuxième transistor de commutation (S2) ;
dans lequel le dispositif de commande est configuré pour :
envoyer un premier signal de commande au premier transistor de commutation (S1), envoyer un deuxième signal de commande au deuxième transistor de commutation (S2), envoyer un troisième signal de commande au troisième transistor de commutation (S3) et envoyer un quatrième signal de commande au quatrième transistor de commutation (S4), pour mettre en œuvre une commande complémentaire sur le premier transistor de commutation (S1) et le troisième transistor de commutation (S3), et mettre en œuvre une commande complémentaire sur le deuxième transistor de commutation (S2) et le quatrième transistor de commutation (S4), dans lequel
le deuxième signal de commande a N impulsions de commande dans chaque cycle du premier signal de commande, le quatrième signal de commande a N impulsions de commande dans chaque cycle du troisième signal de commande, et l'inductance a N+1 cycles de charge et de décharge dans chaque cycle du premier ou du troisième signal de commande, dans lequel N est un entier et N≥3 ; et
dans lequel une fréquence correspondant à chacune des N impulsions de commande dans le deuxième signal de commande ou le quatrième signal de commande est différente.

2. Convertisseur de courant continu bidirectionnel (1) selon la revendication 1, dans lequel, dans tout cycle du premier transistor de commutation (S1), il existe un délai entre un moment d'activation du premier transistor de commutation (S1) et un moment d'activation du deuxième transistor de commutation (S2).

3. Convertisseur de courant continu bidirectionnel (1) selon la revendication 2, dans lequel un cycle du premier transistor de commutation (S1) est le même qu'un cycle du troisième transistor de commutation (S3).

4. Convertisseur de courant continu bidirectionnel (1) selon la revendication 2 ou 3, dans lequel le dispositif de commande est en outre configuré pour :
commander une quantité de temps d'activation du quatrième transistor de commutation (S4) pour qu'elle soit supérieure à une quantité de temps d'activation du troisième transistor de commutation (S3) dans un même cycle, afin de réduire les pertes du troisième transistor de commutation (S3) et du quatrième transistor de commutation (S4).

5. Convertisseur de courant continu bidirectionnel (1) selon l'une quelconque des revendications 1 à 4, dans lequel les N impulsions de commande dans le deuxième signal de commande sont dans des périodes de temps de niveau bas de chaque cycle du premier signal de commande.

6. Convertisseur de courant continu bidirectionnel (1) selon l'une quelconque des revendications 1 à 5, dans lequel une première partie d'impulsions des N impulsions de commande du quatrième signal de commande sont dans des périodes de temps de niveau bas de chaque cycle du troisième signal de commande ; et une seconde partie d'impulsions des N impulsions du quatrième signal de commande sont dans des périodes de temps de niveau haut de chaque cycle du troisième signal de commande.

7. Convertisseur de courant continu bidirectionnel (1) selon l'une quelconque des revendications 1 à 6, dans lequel une largeur d'impulsion de chacune des N impulsions de commande dans le deuxième signal de commande ou le quatrième signal de commande est la même.

8. Convertisseur de courant continu bidirectionnel (1) selon l'une quelconque des revendications 1 à 7, dans lequel, dans chaque cycle du premier signal de commande, un front montant d'une première impulsion de commande des N impulsions de commande dans le deuxième signal de commande est en retard par rapport à un front descendant du premier signal de commande.

9. Convertisseur de courant continu bidirectionnel (1) selon la revendication 8, dans lequel, dans chaque cycle du troisième signal de commande, un front montant d'une première impulsion de commande des N impulsions de commande dans le quatrième signal de commande est en avance par rapport à un front descendant du troisième signal de commande.

10. Convertisseur de courant continu bidirectionnel (1) selon la revendication 9, dans lequel, dans chaque cycle du premier signal de commande, un temps entre le front montant du premier signal de commande et le front montant de la première impulsion de commande des N impulsions de commande dans le deuxième signal de commande est un temps de retard ; ou
dans chaque cycle du troisième signal de commande, un temps entre un front montant du troisième signal de commande et le front montant de la première impulsion de commande des N impulsions de commande dans le quatrième signal de commande est un temps de retard.

11. Convertisseur de courant continu bidirectionnel (1) selon la revendication 10, dans lequel le dispositif de commande est en outre configuré pour :
dans chaque cycle de charge et de décharge de l'inductance (L), commander un courant de charge de l'inductance (L) pour être égal à un courant de décharge de l'inductance (L) afin d'obtenir le temps de retard.

12. Convertisseur de courant continu bidirectionnel (1) selon la revendication 11, dans lequel le dispositif de commande est spécifiquement configuré pour :
obtenir le temps de retard sur la base d'une première tension du convertisseur de courant continu bidirectionnel (1), d'une seconde tension du convertisseur de courant continu bidirectionnel (1), d'une tension du condensateur (C) et du cycle du premier signal de commande/du troisième signal de commande, dans lequel
la première tension est utilisée pour indiquer une tension d'entrée du convertisseur de courant continu bidirectionnel (1), et la seconde tension est utilisée pour indiquer une tension de sortie du convertisseur de courant continu bidirectionnel (1) ; ou
la première tension est utilisée pour indiquer une tension de sortie du convertisseur de courant continu bidirectionnel (1), et la seconde tension est utilisée pour indiquer une tension d'entrée du convertisseur de courant continu bidirectionnel (1).

13. Convertisseur de courant continu bidirectionnel (1) selon la revendication 12, dans lequel le dispositif de commande est spécifiquement configuré pour :
obtenir le temps de retard selon la formule suivante : (V₁ + V_{c} - V₂)D₁T_{sw} = (V₂ - V₁)D₂T_{sw}, dans lequel le temps de retard est (D₁ + D₂)T_{sw} ; et
dans la formule, V₁ représente la première tension du convertisseur de courant continu bidirectionnel (1), V₂ représente la seconde tension du convertisseur de courant continu bidirectionnel (1), V_{c} représente la tension du condensateur (C), T_{sw} représente le cycle du premier signal de commande ou du troisième signal de commande, D₁ représente un rapport cyclique du premier signal de commande et D₂T_{sw} représente un temps de retard entre le front montant de la première impulsion de commande des N impulsions de commande dans le deuxième signal de commande et le front descendant du premier signal de commande.

14. Convertisseur de courant continu bidirectionnel (1) selon la revendication 10, dans lequel le dispositif de commande est en outre configuré pour :
obtenir le temps de retard sur la base de la perte du premier transistor de commutation (S1) et/ou de la perte du deuxième transistor de commutation (S2), ou
obtenir le temps de retard sur la base de la perte du troisième transistor de commutation (S3) et/ou la perte du quatrième transistor de commutation (S4),
ou le dispositif de commande est en outre configuré pour :
obtenir le temps de retard sur la base d'un courant d'ondulation de l'inductance (L) et de la perte d'au moins l'un du premier transistor de commutation (S1) et/ou du deuxième transistor de commutation (S2) ; ou
obtenir le temps de retard sur la base d'un courant d'ondulation de l'inductance (L) et de la perte d'au moins l'un du troisième transistor de commutation (S3) et/ou du quatrième transistor de commutation (S4),
dans lequel chaque cycle du premier signal de commande est identique à chaque cycle du troisième signal de commande,
dans lequel le convertisseur de courant continu bidirectionnel (1) comprend en outre un cinquième transistor de commutation ; et
une première borne du cinquième transistor de commutation est connectée à la seconde borne du condensateur (C), et une deuxième borne du cinquième transistor de commutation est connectée au deuxième nœud.

15. Procédé de commande d'un convertisseur de courant continu bidirectionnel (1), dans lequel le convertisseur de courant continu bidirectionnel (1) comprend un premier transistor de commutation (S1), un deuxième transistor de commutation (S2), un troisième transistor de commutation (S3), un quatrième transistor de commutation (S4), un condensateur (C), une inductance (L) et un dispositif de commande, dans lequel
une première borne de l'inductance (L) est connectée à une première borne de courant continu du convertisseur de courant continu bidirectionnel (1), une seconde borne de l'inductance (L) est connectée à un premier nœud, une première électrode du premier transistor de commutation (S1) est connectée au premier nœud, une seconde électrode du premier transistor de commutation (S1) est connectée à un deuxième nœud, une première électrode du deuxième transistor de commutation (S2) est connectée au deuxième nœud, une seconde électrode du deuxième transistor de commutation (S2) est connectée à une deuxième borne de courant continu du convertisseur de courant continu bidirectionnel (1) et à une quatrième borne de courant continu du convertisseur de courant continu bidirectionnel (1), une première électrode du troisième transistor de commutation (S3) est connectée au premier nœud, une seconde électrode du troisième transistor de commutation (S3) est connectée à un troisième nœud, une première électrode du quatrième transistor de commutation (S4) est connectée au troisième nœud, une seconde électrode du quatrième transistor de commutation (S4) est connectée à une troisième borne de courant continu du convertisseur de courant continu bidirectionnel (1), une première borne du condensateur (C) est connectée au troisième nœud, une seconde borne du condensateur (C) est connectée au deuxième nœud, et le dispositif de commande est connecté au premier transistor de commutation (S1), au deuxième transistor de commutation (S2), au troisième transistor de commutation (S3) et au quatrième transistor de commutation (S4) ; et
le procédé de commande comprend :
la réalisation, par le dispositif de commande, d'une commande complémentaire sur le premier transistor de commutation (S1) et le troisième transistor de commutation (S3), et la réalisation d'une commande complémentaire sur le deuxième transistor de commutation (S2) et le quatrième transistor de commutation (S4), dans lequel la commande complémentaire est utilisée pour indiquer que deux transistors de commutation en commande complémentaire ne peuvent pas être simultanément allumés ou éteints ;
dans lequel le procédé comprend spécifiquement :
la commande d'une quantité de temps d'activation du deuxième transistor de commutation (S2) pour qu'elle soit supérieure à une quantité de temps d'activation du premier transistor de commutation (S1) dans un même cycle, afin de réduire les pertes du premier transistor de commutation (S1) et du deuxième transistor de commutation (S2) ;
dans lequel le dispositif de commande est configuré pour :
envoyer un premier signal de commande au premier transistor de commutation (S1), envoyer un deuxième signal de commande au deuxième transistor de commutation (S2), envoyer un troisième signal de commande au troisième transistor de commutation (S3) et envoyer un quatrième signal de commande au quatrième transistor de commutation (S4), pour mettre en œuvre une commande complémentaire sur le premier transistor de commutation (S1) et le troisième transistor de commutation (S3), et mettre en œuvre une commande complémentaire sur le deuxième transistor de commutation (S2) et le quatrième transistor de commutation (S4), dans lequel
le deuxième signal de commande a N impulsions de commande dans chaque cycle du premier signal de commande, le quatrième signal de commande a N impulsions de commande dans chaque cycle du troisième signal de commande, et l'inductance a N+1 cycles de charge et de décharge dans chaque cycle du premier ou du troisième signal de commande, dans lequel N≥3 ; et
dans lequel une fréquence correspondant à chacune des N impulsions de commande dans le deuxième signal de commande ou le quatrième signal de commande est différente.
